(19) Europäisches Patentamt / European Patent Office / Office européen des brevets

(11) **EP 3 955 482 B1**

(12) **EUROPEAN PATENT SPECIFICATION**

(45) Date of publication and mention
of the grant of the patent:
**13.12.2023 Bulletin 2023/50**

(21) Application number: **20305929.0**

(22) Date of filing: **14.08.2020**

(51) International Patent Classification (IPC):
**H04L 1/00** $^{(2006.01)}$     **H03M 13/11** $^{(2006.01)}$
**H04L 1/20** $^{(2006.01)}$

(52) Cooperative Patent Classification (CPC):
**H04L 1/0042; H03M 13/036; H03M 13/251;
H04L 1/0057; H04L 1/20**

(54) **DEVICE AND METHOD FOR LINEAR ERROR CORRECTION CODES CONSTRUCTION**

VORRICHTUNG UND VERFAHREN ZUR KONSTRUKTION LINEARER
FEHLERKORREKTURCODES

DISPOSITIF ET PROCÉDÉ DE CONSTRUCTION DE CODES DE CORRECTION D'ERREUR
LINÉAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.02.2022 Bulletin 2022/07**

(73) Proprietor: **Eurecom G.I.E
06410 Biot-Sophia Antipolis (FR)**

(72) Inventor: **KNOPP, Raymond
06410 BIOT (FR)**

(74) Representative: **Atout PI Laplace
Immeuble "Visium"
22, avenue Aristide Briand
94117 Arcueil Cedex (FR)**

(56) References cited:
**EP-A1- 3 291 449**

• **KULHANDJIAN MICHEL ET AL: "Code Design for
Noncoherent Detection in Satellite
Communication Systems", 2020
INTERNATIONAL WIRELESS
COMMUNICATIONS AND MOBILE COMPUTING
(IWCMC), IEEE, 15 June 2020 (2020-06-15), pages
52-56, XP033799888, DOI:
10.1109/IWCMC48107.2020.9148569 [retrieved
on 2020-07-24]**

EP 3 955 482 B1

**Description**

**TECHNICAL FIELD**

The invention generally relates to digital communications and in particular to a device and a method for the construction of linear error correction codes for coded modulations.

**BACKGROUND**

Error correction codes relate to reliable transmission and/or storage of data by incorporating some redundant information in the original data. This redundancy enables recovering the original data and/or detecting the presence of errors, even if errors occur up to some tolerance levels.

Error correction codes are used in several digital communication devices and systems to compensate for errors and to provide error-resistant delivery of digital data during data storage and/or transmission.

Error correction codes can be used in many devices such as computers, disks, cellular phones, user equipments, base stations, etc. Error correction codes can be also used in different types of systems such as transmission systems such as wireless ad-hoc networks (e.g. standardized in Wi-Fi 802.11), radio communication systems (e.g. standardized in 3G, 4G/LTE, 5G and beyond), optical fiber-based transmission systems, and digital video broadcasting (e.g. standardized in DVB-C2, DVB-S2X, and DVB-T2).

Existing error correction codes comprise linear codes and non-linear codes. Linear codes represent codes that satisfy a linearity property according to which any linear combination of codeword vectors is a codeword vector. Linear codes are widely used as they are less complex and easier to implement than non-linear codes. Linear codes are generally partitioned into block codes and convolutional codes.

A linear error correction code can be represented by a generator matrix and a parity-check matrix. The generator matrix is used in the encoding process to generate codeword vectors comprising components. The values of the components of each codeword vector (also referred to as 'symbols') depend on the entries of the generator matrix (equivalently on the entries of the parity-check matrix). In particular, a linear block code of length $N$ and rank $B$ encodes a block of symbols of length $N$ into a codeword vector of length > $N$, by adding $N$ - $B$ redundancy symbols. The redundant symbols are used to detect and possibly correct any error that occurred during the transmission of the codeword vector.

The entries of the generator matrix and the parity-check matrix as well as the symbols comprised in the codeword vectors belong to the algebraic structure over which the error correction code is constructed. For example, for linear codes constructed on Galois fields of order $q \geq 2$, noted $GF(q)$, the symbols comprised in a codeword vector take values in $GF(q)$. A codeword vector is thus a vector of $N$ symbols that each belong to $GF(q)$. The code is a binary code if the symbols belong to $GF(2)$. In contrast, when $q > 2$, the code is a non-binary code.

Digital modulation techniques convert a digital signal into a modulated signal in the form of a sequence of modulated symbols represented as signal points that belong to a signal constellation. The signal constellation depends on the modulation scheme used for the modulation and represents the values that can be taken by each symbol as points in the Euclidean space. The components of the digital signal are mapped onto symbols using a modulation mapping which associates a symbol from the signal constellation with each value of the digital signal. Exemplary digital modulation schemes comprise amplitude-shift keying (ASK), frequency-shift keying (FSK), phase-shift keying (PSK), and quadrature amplitude modulation (QAM). Exemplary modulation mappings comprise the Gray mapping which uses a binary representation of the components of the digital signal.

The concatenation of error correcting codes and modulation provides coded modulations. An exemplary coded modulation scheme determination device and method has been disclosed for example in EP 3 291 449 A1. In coded modulations, coding can be seen as a patterning of the continuous time signals, and of the phases and/or the amplitudes of the time signals.

Almost all codes implemented in modern communication systems such as 3 GPP (3rd Generation Partnership project) systems are based on code constructions on the assumption that the detection at the receiver is an ideal coherent detection, which corresponds to an assumption that there is no channel uncertainty. When the channel is unknown, channel uncertainty may be overcome by performing channel estimation using pilot signals and performing quasi-coherent detection based on the estimated channel rather than the true channel. Such strategy induces a performance loss due to the overhead incurred by the use of the pilot signals and the use of the estimated channel instead of the true channel. However, existing approaches do not provide solutions for constructing binary error correction codes under channel uncertainty, while such codes are essential in modern communication and transmission systems to ensure efficient, reliable, and error-resilient data transmission.

There is accordingly a need for methods and devices that enable constructing error correction codes for coded modulation schemes under channel uncertainty.

## SUMMARY

In order to address these and other problems, there is provided a coded modulation device for determining one or more linear error correcting codes, the coded modulation device comprising:

- a calculation unit configured to determine two or more candidate generator matrices, each candidate generator matrix defining a linear error correcting code and comprising values selected from a predefined set of values, each candidate generator matrix providing a set of codeword vectors from input vectors, said input vectors comprising values selected from said predefined set of values;
- a metric determination unit configured to associate a vector metric to each pair of codeword vectors provided by each candidate generator matrix for a predefined modulation scheme and to associate a matrix metric to each candidate generator matrix, matrix, a pair of codeword vectors comprising a zero-valued codeword vector and a non-zero valued codeword vector, a matrix metric associated with a candidate generator matrix being the minimum value among the vector metrics associated with the pairs of codeword vectors provided by said candidate generator matrix;
- a selection unit configured to select the one or more candidate generator matrices that are associated with the highest matrix metric among said two or more candidate generator matrices, the one or more linear error correcting codes are represented by said selected one or more candidate generator matrices.

According to some embodiments, the selection unit may be configured to select, among the one or more candidate generator matrices associated with the highest matrix metric, the candidate generator matrix that is associated with the highest matrix metric and that provides a minimum number of pairs of codeword vectors that are associated with a vector metric equal to said highest matrix metric.

According to some embodiments, the calculation unit may be configured to previously determine a first set of candidate generator matrices comprising two or more candidate generator matrices and to determine at least one candidate generator matrix from the first set of candidate generator matrices.

According to some embodiments, calculation unit may be configured to determine extended codeword vectors from the codeword vectors provided by the selected one or more candidate generator matrices using a code extension by applying a complex or a real Hadamard matrix of one or more codes.

According to some embodiments, each pair of codeword vectors may comprise a first codeword vector and a second codeword vector, the calculation unit being configured to determine a first value by mapping the first codeword vector using the predefined modulation scheme and to determine the second value by mapping the second candidate vector using the predefined modulation scheme, the metric determination unit being configured to determine the vector metric associated with each pair of codeword vectors as the absolute value of the pairwise correlation between the first value and the second value.

According to some embodiments, the linear error correcting code may be binary or quarternary code.

According to some embodiments, the linear error correcting code may be used to encode control data transmitted over a physical control channel in a transmission system.

There is also provided a computer-implemented method for determining one or more linear error correcting codes, the method comprising:

- determining two or more candidate generator matrices, each candidate generator matrix defining a linear error correcting code and comprising values selected from a predefined set of values, each candidate generator matrix providing a set of codeword vectors from input vectors, the input vectors comprising values selected from the predefined set of values;
- determining a vector metric in association with each pair of codeword vectors provided by each candidate generator matrix for a predefined modulation scheme, matrix, a pair of codeword vectors comprising a zero-valued codeword vector and a non-zero valued codeword vector;
- determining a matrix metric in association with each candidate generator matrix, a matrix metric associated with a candidate generator matrix being the minimum value among the vector metrics associated with the pairs of codeword vectors provided by the candidate generator matrix;
- selecting the one or more candidate generator matrices that are associated with the highest matrix metric among the two or more candidate generator matrices, the one or more linear error correcting codes are represented by the selected one or more candidate generator matrices.

Advantageously, the embodiments of the invention provide constructions of linear error correcting codes optimized for the non-coherent metric and providing performance approaching the optimal performance obtained using orthogonal codes while using less signaling dimensions.

Advantageously, the embodiments of the invention provide efficient short block-length codes for user-plane transmission and/or control signaling.

Advantageously, the embodiments of the invention provide efficient and low decoding complexity short block-lengths and/or low-spectral efficiency codes adapted to 3GPP resource grids, in particular to transmission formats in NR or LTE/NR transmission systems.

Advantageously, the embodiments of the invention enable increasing the sensitivity of the base stations in LTE/NR transmission systems, which provides enhanced coverage for physical uplink control channels.

Further advantages of the present invention will become clear to the skilled person upon examination of the drawings and the detailed description.

## BRIEF DESCRIPTION OF THE DRAWINGS

The accompanying drawings, which are incorporated in and constitute a part of this specification, illustrate various embodiments of the invention together with the general description of the invention given above, and the detailed description of the embodiments given below.

Figure 1 illustrates an exemplary system implementing a coded modulation device, according to some embodiments of the invention;

Figure 2 is a block diagram representing a coded modulation device, according to some embodiments of the invention; and

Figure 3 is a flowchart depicting a method for determining a linear error correcting code, according to some embodiments of the invention.

## DETAILED DESCRIPTION

Embodiments of the present invention provide devices and methods for constructing coded modulation schemes from optimized linear error correcting codes and modulation mappings that enable improved decoding performance approaching the optimal performance of orthogonal codes.

Such coded modulation schemes can be used for encoding and modulating a digital data sequence in any device and system adapted to convert digital data sequences into coded modulation symbols.

Advantageously, the coded modulation schemes can improve system spectral efficiency and provide resistance to impairments in transmission and storage systems.

Devices and methods according to the various embodiments of the present invention may be implemented in many types of digital storage and transmission devices and systems, in various types of applications. Exemplary devices and systems comprise without limitation computers, disks, laptops, phones, smartphones, recorders, base stations, drones, satellites, etc. Exemplary applications comprise magnetic and optical recording, digital television and video broadcasting, digital communications, positioning systems, spacecraft systems, etc.

The following description of certain embodiments of the invention will be made with reference to an application of the invention to communication systems, for illustration purpose only. However, the skilled person will readily understand that the embodiments of the invention may be implemented in other types of systems and applications.

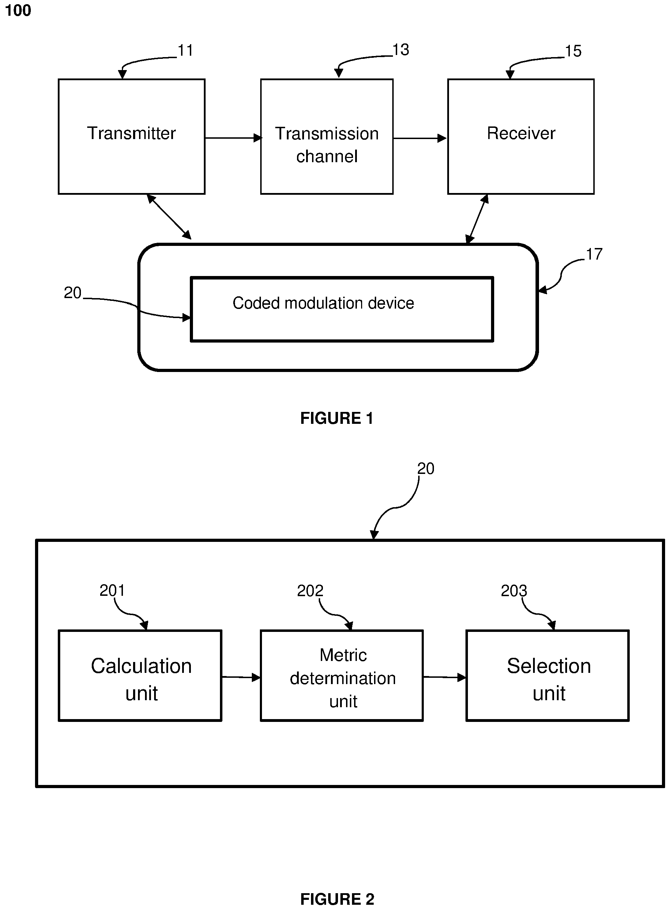

Figure 1 illustrates an exemplary communication system 100 in which embodiments of the invention can be implemented.

The communication system 100 may be for example:

- wired (e.g. optical fiber-based);
- wireless (e.g. radio communication systems);
- acoustic (e.g. underwater acoustic communication systems);
- molecular (used for example in underground structures e.g. tunnels and pipelines or in underwater environments).

The communication system 100 may comprise at least one transmitter device 11 (hereinafter referred to as a "transmitter") configured to transmit a plurality of information symbols to at least one receiver device 15 (hereinafter referred to as "receiver") through a transmission channel 13. The receiver device 15 may be configured to receive the signal conveyed by the transmitter 11 and decode the received signal to recover the original data. The transmission channel 13 may be any transmission channel adapted to transmit information symbols from the transmitter device 11 to the receiver device 15, depending on the type of the communication system, such as for example a wired connection channel, a wireless medium, an underwater communication channel, etc.

In an application of the invention to wired communication systems such as computer networking systems, the transmitter 11 and/or the receiver 15 may be any device configured to operate in a wired network. Exemplary devices adapted to such application comprise computers, routers or switches connected to a small or large area wired network. Further, in such an application, the transmission channel 13 may be any type of physical cable used to ensure the transfer of data between the different devices connected in the wired network.

In another application of the invention to wireless communication systems such as ad-hoc wireless networks used in local area communications, wireless sensor networks and radio communication systems (e.g. LTE, LTE-advanced, 5G and beyond), the transmitter 11 and/or the receiver 15 may be any type of fixed or mobile wireless device configured to operate in a wireless environment. Exemplary devices adapted to wireless communication systems comprise laptops, tablets, mobile phones, robots, IoT (Internet of Things) devices, base stations, etc. The transmission channel 13 may be any wireless propagation medium suitable for this type of application. Exemplary applications comprise Machine-To-Machine (M2M), Web-of-Things (WoT), and Internet of Things (IoT) (for example vehicle-to-everything communications) involving networks of physical devices, machines, vehicles, home alliances and many other objects connected to each other and provided with a connectivity to the Internet and the ability to collect and exchange data without requiring human-to-human or human-to-computer interactions. IoT devices may require low bandwidth, and/or low power consumption, and/or low data rates. In such IoT applications, the communication system 100 may be a wireless network, for example a wireless wireless IoT/M2M network representing low energy power-consumption/long battery life/low-latency/low hardware and operating cost/high connection density constraints such as low-power wide area networks and low-power short-range IoT networks. Exemplary technologies used in such applications may comprise 5G, LTE-NB1 (Long Term Evolution-Machine to Machine, Narrow Band) and NB-IoT (NarrowBand IoT).

In such applications, the communication system 100 may be any IoT network or any M2M network used in consumer, commercial, industrial, and infrastructure applications. Exemplary consumer applications comprise connected vehicles (Internet of Vehicles IoV), home automation/smart home, smart cities, wearable technology, and connected health. Exemplary commercial applications comprise medical and healthcare and transportation. In medicine, a digitized healthcare system connecting medical resources and healthcare services may be used in which special monitors and sensors are used to enable remote health monitoring and emergency notification. In transportation systems, IoT using for example wireless sensors, can provide interaction between the vehicles and the infrastructure as well as inter and intra vehicular communications, smart traffic control, smart parking, and safety and road assistance. Exemplary industrial applications comprise applications in agriculture for example in farming using sensors to collect data on temperature, rainfall, humidity, wind speed, and soil content. Exemplary infrastructure applications comprise the use of IoT devices to perform monitoring and controlling operations of urban and rural infrastructures such as bridges and railway tracks.

In such applications, the transmitter 11 and/or the receiver 15 may be any physical internet-enabled device/object provided with required hardware and/or software technologies enabling communication over Internet. The transmitter 11 and/or the receiver 15 may be any standard internet connected-devices such as desktop computers, servers, virtual machines laptops, smart-phones, tablets. In some embodiments, the transmitter 11 and/or the receiver 15 may be any IoT/M2M device or connected device operating in an IoT/M2M network such as medical devices, temperature and weather monitors, connected cards, smart meters, game consols, personal digital assistants, health and fitness monitors, lights, thermostats, appliances, garage doors, security devices, drones, smart clothes, eHealth devices, robots, and smart outlets. An IoT/M2M device may be any physical device, vehicle, home appliance, or any object/thing embedded with electronics, software, sensors, actuators, and connectivity enabling remote connection for data collection and exchange with an IoT/M2M platform for example. A sensor may be any sensory organ/object/device (e.g. a transducer) that can measure a characteristic such as temperature, humidity/moisture, acoustic/sound/vibration, chemical/Gas, force/load/strain/pressure, electric/magnetic, machine vision/optical/ambient light, or position/presence/proximity.

The transmitter 11 and/or the receiver 15 may be fixed or mobile and/or may be remotely monitored and/or controlled. The transmitter 11 and/or the receiver 15 may be equipped with power sources that provide power to the different components ensuring the operation of these devices (e.g. dry cell batteries, solar cells, and fuel cells).

The transmission channel 13 may represent any wireless network enabling IoT in licensed or license-free spectrum. Exemplary wireless networks comprise low-power short range networks and LPWANs. Exemplary LPWAN technologies comprise LTE-NB1 and NB-IoT.

Further, the transmission channel 13 may accommodate several pairs of transmitters 11 and receivers 15. In such embodiments, multiple access techniques and/or network coding techniques may be used in combination with error correction codes and modulation. Exemplary multiple access techniques comprise Time Division Multiple Access (TDMA), Frequency Division Multiple Access (FDMA), Code Division Multiple Access (CDMA), and Space Division Multiple Access (SDMA).

In still another application of the invention to optical communication systems such as optical fiber-based systems, the transmitter 11 and the receiver 15 may be any optical transceiver device respectively configured to transmit and receive data information propagated over an optical link. Exemplary optical communication systems comprise Polarization Division Multiplexing (PMD) and Mode Division Multiplexing (MDM) systems.

For any type of wired, wireless or deep-space (e.g. satellites, telescopes, space probes, etc.) communication systems, the transmission channel 13 may be a noisy channel. For example, the noise may result from the thermal noise of the system components and/or the intercepted interfering radiation by antennas. Other exemplary sources of noise comprise switching, manual interruptions, electrical sparks and lightning. In some embodiments, the total noise may be modeled by an additive white Gaussian noise (AWGN). The transmission channel 13 may be a multipath channel using single-carrier or multi-carrier modulation formats such as OFDM (Orthogonal Frequency Division Multiplexing) and FBMC (Filter Bank Multi-Carrier) for mitigating frequency-selectivity, interference and delays.

Further, according to another application of the invention to digital mass storage, the transmission channel 13 may be modeled for example by an erasure channel, a binary symmetric channel, or a Gaussian channel. In such application, the transmission channel 13 may be any type of storage device which can be sent to (i.e. written) and received from (i.e. read).

The various embodiments of the invention may be implemented in a management device 17 arranged in the system 100. In particular, the management device 17 may comprise a coded modulation device 20 configured to determine one or more linear error correcting codes. The coded modulation device 20 may be configured to communicate the constructed one or more linear error correcting codes to the transmitter 11 for encoding and modulating a sequence of data to be sent to at least one receiver 15. The coded modulation device 20 may be further configured to communicate the constructed one or more linear error correcting codes to at least one receiver 15 such that the at least one receiver 15 is able to decode the signal received from the transmitter 11 and recover the original sequence of data.

According to some embodiments, data transmission in the communication system 100 may correspond to an uplink communication scenario during which the receiver 15 is configured to receive data from one or more transmitters 11 operating in a wireless environment. The receiver 15 may be a base station, a relay station, an eNodeB/gNodeB in a cellular network, an access point in a local area network or in ad-hoc network or any other interfacing device operating in a wireless environment. The transmitter 11 may be, without limitation, a mobile phone, a computer, a laptop, a tablet, a drone, an IoT device etc.

According to some embodiments, the transmitter 11 and/or the receiver 15 may be equipped with a plurality of transmit and/or receive antennas. In such embodiments, space-time coding and/or space-time decoding techniques may be used in combination with coded modulations for encoding data both in the time and space dimensions, thereby exploiting space and time diversities of multiple antennas.

According to some embodiments, the transmitter 11 may comprise an error correction code encoder (not represented in figure 1) implementing one or more error correction codes constructed by the coded modulation device 20.

A linear block code of length $N$ and rank $B$ encodes a block of symbols of length $B$ into codeword vector, of length $> B$, by adding $N - B$ redundancy symbols called 'parity symbols'. The extra parity symbols are used to detect and possibly correct any error that occurred during the transmission. Such linear codes may be represented using a 'codebook' denoted by $\mathcal{C}$, a 'matrix' denoted by $G(B,N)$ or a 'graph' representation.

The codebook representation defines the dictionary $\mathcal{C}$ of allowable codewords and the algebraic structure to which they belong. For example, for linear codes constructed on Galois fields of order $q \geq 2$, noted $GF(q)$, the components comprised in a codeword take values in $GF(q)$. A codeword is thus a vector of $N$ components that each belong to $GF(q)$. The code is binary if the symbols belong to $GF(2)$. In contrast, when $q > 2$, the code is non-binary. In some embodiments, non-binary linear codes with may be constructed over the ring of integers.

The matrix representation of a linear block code defines a generator matrix, denoted by $G$, and a parity-check matrix, denoted by $H$, linked by the relation $G. H^t = 0$. Entries of the generator and parity-check matrices belong to the algebraic structure over which the code is constructed. The parity-check matrix defines the parity-check constraints which are to be satisfied by the codewords. In particular, non-zero entries of each row of the parity-check matrix define a parity-check equation to be satisfied by any codeword. Using a row notation of vectors, the generator matrix $G(B, N)$ is of dimensions $B \times N$ while the parity-check matrix is of dimensions $(N - B) \times N$. The components of the generator matrix are denoted by $G_{i,j}$ with $i = 1, ..., B$ designating the row index and $j = 1, ..., N$ designating the column index of the component $G_{i,j}$.

According to some embodiments, the generator matrix $G(N, B)$ may be represented in a systematic form such that the generator matrix is written as:

$$G(N, B) = (I_B \quad G_{B \times N-B}) \tag{1}$$

In equation (1), $I_B$ designates the identity matrix of dimensions $B \times B$ and $G_{B \times N-B}$ designates a rectangular matrix comprising $B$ lines or row vectors and $N - B$ columns or column vectors. The $k^{th}$ row vector of the rectangular matrix $G_{B \times N-B}$ is denoted by $g_k = (G_{k,1} \ G_{k,2} \cdots G_{k,N-B})$, with $k = 1, ... , B$.

Accordingly, the error correcting code encoder may be configured to receive a digital input data block of length, *B* denoted by *u,* and to encode the digital input data block into a codeword vector, denoted *c,* using a linear error correcting code *C(B,N)* provided by the coded modulation device 20. The digital input data block comprises *B* components (bits) and the generated codeword vector *c* comprises *N* components. The error correcting code is constructed over a given algebraic structure, denoted by *F,* and the components of the digital input data block belong to the given algebraic structure *F* and is represented by a generator matrix *G*(*N, B*) in a systematic form, without loss of generality.

According to some embodiments, the algebraic structure *F* may be any non-zero commutative division ring, also called a "field". Exemplary fields comprise the field of real numbers, the field of complex numbers, the field of rational numbers, and finite fields (also known as 'Galois fields').

A finite field is represented by a set of values comprising a finite number of values. The number of values in the set of values represents the order of the finite field. In the following, the set of values of finite fields *F = GF* will be denoted by *GF(q), q* designating the order of the finite field *GF.* The components of the digital input block and the components of the codeword vectors comprised in the codebook generated by the error correcting code determined by the coded modulation device are accordingly selected from the set of values *GF(q).*

The transmitter 11 may further comprise a modulator (not represented in figure 1) configured to implement a modulation scheme denoted by $\mathcal{M}$ to determine a modulated sequence of symbols denoted by *s* by applying a modulation scheme using a modulation mapping $\pi$, the given modulation scheme modulating the components of the codeword vector *c* to symbols comprised in a given set of symbols denoted by $\mathcal{S}$. Each symbol is represented as a point in the signal constellation associated with the modulation scheme. The signal constellation comprises a number of points (hereinafter referred to as 'signal points' or 'constellation points'), each point corresponding to a symbol in the set of symbols $\mathcal{S}$.

According to some embodiments, the modulation scheme $\mathcal{M}$ may be one-dimensional. In such embodiments, the signal constellation is a one-dimensional diagram in which the signal points belong to a same line. Exemplary one-dimensional modulation schemes comprise pulse amplitude modulations (PAM) and BPSK modulation (Binary Phase Shift Keying).

According to other embodiments, the modulation scheme $\mathcal{M}$ may be two-dimensional. In such embodiments, the signal constellation is a diagram in the complex plane represented by the two-dimensional Euclidean space. More specifically, the signal constellation is a sub-set of the two-dimensional real field $\mathbb{R}^2$, in which each signal point is represented by a couple of coordinates that depend on the modulation scheme $\mathcal{M}$. The symbols are accordingly represented as complex numbers modulating a cosine and sine carrier signal with the real and imaginary parts and can be sent using two carriers on the same frequency, referred to as 'quadrature carriers'. The modulated vector *s* may be a complex-value vector comprising $\kappa$ complex-value symbols $s_1, s_2, ..., s_\kappa$ with q bits per symbol. An information symbol $s_j$ has a mean power $E_s$, and can be written in the form:

$$s_j = R\big(s_j\big) + iI\big(s_j\big) \qquad (2)$$

In equation (2), *i* denotes the complex number such that $i^2 = -1$, the *R*(.) operator corresponds to the real part of the input value $s_j$, and *I*(.) Corresponds to the imaginary part of an input value $s_j$.

When modulation formats such as $2^q$-QAM are used, the $2^q$ symbols or states represent a sub-set of the integer field *Z*[*i*]. The corresponding constellation is composed of $2^q$ points representing the different states or symbols. In addition, in the case of squared modulations, the real and imaginary parts of the information symbols belong to the same finite alphabet *A* = [-(*q* - 1), (*q* - 1)]. The minimum distance $d_{min}$ of a modulation scheme represents the Euclidean distance between two adjacent points in the constellation and is equal to 2 in such example.

The real and imaginary axes in the complex plane are respectively called the 'in phase' and the 'quadrature' axes. Accordingly, for two-dimensional modulation schemes $\mathcal{M}$, a modulation mapping $\pi$ associates each value of the components $c_j$ in the set of values *GF(q)* with a symbol

$$s_j \in \mathcal{S}$$

according to: $\pi : GF(q) \rightarrow \mathbb{R}^2$

$$c_j \mapsto \pi\big(c_j\big) = \Big(\pi^I\big(c_j\big), \pi^Q\big(c_j\big)\Big) = s_j = \Big(s_j^I, s_j^Q\Big) \qquad (3)$$

In equation (3), $s_j^I = \pi^I(c_j)$ (respectively $s_j^Q = \pi^Q(c_j)$) designates the in-phase (respectively the quadrature) coordinate of the mapped component $\pi(c_j)$.

Exemplary two-dimensional modulation schemes comprise frequency-shift keying (FSK), phase-shift keying (PSK), and quadrature amplitude modulation (QAM). $2^q$-QAM and $2^q$-PSK define $2^q$ symbols or states.

The number of symbols comprised in the set of symbols $\mathcal{S}$ (respectively the number of points in the signal constellation) represents the order of the modulation scheme $\mathcal{M}$.

According to another embodiment, the modulation scheme $\mathcal{M}$ may be a multidimensional modulation of a dimension higher than or equal to three. Exemplary multidimensional modulation formats comprise polarization-multiplexed QAM and polarization-multiplexed QPSK used for example in optical fiber communications.

According to some embodiments, the modulation scheme $\mathcal{M}$ may be a higher-order modulation, i.e. a modulation of an order higher than or equal to four (4).

According to some embodiments, the order of the modulation scheme $\mathcal{M}$ may be equal to the order of the finite field over which the linear error correcting code is constructed.

According to other embodiments, the order of the modulation scheme $\mathcal{M}$ may be different from the order of the finite field *GF*.

For any dimension and any order of the modulation scheme $\mathcal{M}$, the distance between every two different signal points in the corresponding signal constellation corresponds to the Euclidean distance between the two points in the Euclidean space ($\mathbb{R}$ for one-dimensional modulation schemes and $\mathbb{R}^2$ for two-dimensional modulation schemes). In particular, the minimum Euclidean distance of the modulation scheme $\mathcal{M}$ corresponds to the smallest Euclidean distance evaluated over all different signal points representing the different symbols in the set of symbols $\mathcal{S}$.

Accordingly, for two-dimensional modulation schemes $\mathcal{M}$, the Euclidean distance $d_{\mathcal{M}}(s_j, s_l)$ between two signal points $s_j \neq s_l$ can be written according to:

$$d_{\mathcal{M}}(s_j, s_l) = \sqrt{\left(s_j^I - s_l^I\right)^2 + \left(s_j^Q - s_l^Q\right)^2} \qquad (4)$$

The minimum Euclidean distance of the modulation scheme $\mathcal{M}$ is then given by:

$$d_{\mathcal{M},min} = \min_{\substack{(s_i,s_j) \in \mathcal{S}^2 \\ s_i \neq s_j}} d_{\mathcal{M}}(s_i, s_j) \qquad (5)$$

In embodiments using BPSK modulations, the components of the digital input data block, the components of the generator matrix and the components of the codeword vector are binary. Further, addition and multiplication operations are assumed to be modulo two ('2').

For BPSK modulations, the error correcting code encoder receives a vector *u* that comprises *B* components and generates an *N*-dimensional codeword vector *c* such that *c = u. G*. The modulator then determines the vector *s* comprising *N* information symbols $s_i$ with *i* = 1, ... , *N* by mapping the components of the codeword vector *c* such that $s_i$ = $2c_i$ - 1 with $c_i$ designating the $i^{th}$ component of the codeword vector *c*.

In embodiments using QPSK modulations, the components of the digital input data block are binary and are modulated to integers modulo four ('4'). The associated arithmetic operations (including addition, subtraction, and multiplication) and the components of the generator matrix are assumed to be modulo four ('4').

For QPSK modulations, the error correcting code encoder determines the *N*-dimensional codeword vector c as c = *u'. G* such that, for even values of *B,* the components of the vector *u'* are given by *u'(i)* = 2u(2i) + u(2i + 1) and for odd values of *B,* the components of the vector *u'* are given by:

$$u'(i) = \begin{cases} 2u(2i) + u(2i+1), & 0 \le i < \left\lfloor \frac{B}{2} \right\rfloor \\ 2u(2i) & i = \left\lfloor \frac{B}{2} \right\rfloor \end{cases} \qquad (6)$$

For QPSK modulations, the modulator then determines the vector $s$ comprising $N$ information symbols $s_i$ with $i = 1, ..., N$ by mapping the components of the codeword vector c such that:

$$s(i) = e^{\alpha\sqrt{-1}}(-1)^{c(i)/2} \qquad (7)$$

In equation (7), $\alpha$ designates an arbitrary real constant known at the receiver 15.

According to some embodiments, the transmitter 11 may further comprise a space-time encoder (not illustrated in figure 1) for performing space-time coding or spatial multiplexing in embodiments in which the transmitter 11 is equipped with a plurality of transmit antennas.

According to some embodiments, each transmit antenna implemented in the transmitter 11 may be associated with a single carrier or a multi-carrier modulator to convert the constructed codeword or vector of spatially multiplexed symbols from the time domain to the frequency domain using a single carrier or a multi-carrier modulation technique. Exemplary multi-carrier modulation techniques comprise OFDM and FBMC. Signals may be sent from the one or more transmit antennas implemented in the transmitter 11 optionally after filtering, frequency transposition and amplification.

According to some embodiments, the digital input data encoded at the transmitter 11 may correspond to control data used in uplink control channels. Exemplary control channels comprise PUCCH ('Physical Uplink Control Channels') and PUSCH ('Physical Uplink Shared Channels). Exemplary transmission formats comprise the LTE/NR PUCCH format 2 and the LTE/NR PUCCH formats 3 and 4 considered in current 3GPP systems.

The symbols of the vector $s$ may represent samples in both time and frequency. In particular, the frequency dimensions may be adjacent carriers in a multi-carrier symbol (for example an OFDM symbol) and the time dimensions may refer to different multi-carrier symbols. In general, a time or frequency dimension is designated by a resource element.

According to some embodiments in application to 3GPP systems, the length $N$ of the linear error correcting code may be given by $N = 12KL$ with $K$ designating the number of physical resource blocks over which coding is performed and $L$ designating the number of symbols.

According to some embodiments in application for example to single-carrier NB-IoT transmissions, the length $N$ of the linear error correcting code may be given by $N = 7L$ with $L$ designating the number of time slots used for the transmission.

The receiver 15 may be configured to receive and decode the signals communicated by the transmitter 11 through the transmission channel 13. The receiver 15 may be integrated in a base station such as a Node-B in a cellular network, an access point in a local area network or ad-hoc networks or any other interfacing device operating in a wireless environment. The receiver 15 may be fixed or mobile. In one exemplary embodiment, the receiver 15 may comprise a demodulator (not illustrated in figure 1) configured to generate a demodulated sequence by performing a demodulation of the received signal, and an error correcting code decoder (not illustrated in figure 1) configured to deliver as output an estimate of the encoded sequence sent over the transmission channel 13.

In one application of the invention to wireless communications, the signals sent by the transmitter 11 may be subject to fading and interference, and the transmission channel 13 may be noisy (affected for example by a Gaussian Noise). In such embodiments, the received signal at the receiver may be written as:

$$y = Ae^{j\theta}s(m) + z \qquad (8)$$

In equation (8), $y$ designates the received signal, $s(m)$ designates the modulated vector and stands for a complex-value N-dimensional vector carrying $B$ information bits such that the message $m = 0,1, ..., 2^B - 1$. The parameter z stands for the additive white Gaussian noise which real and imaginary components are independent and have variance $\sigma^2$ in each dimension. $A$ and $\theta$ respectively refer to the unknown channel amplitude and phase which are assumed to be constant over all dimensions on the received signal $y$. Such assumption involves that linear phase increments due to residual timing offset and/or that frequency offset may be compensated prior to decoding.

The vector of information symbols $s(m)$ may have a constant and unitary amplitude such that $|s(m)| = 1 \ \forall m$.

The receiver 15 may implement a reverse processing of the processing performed in the transmitter 11. Accordingly, if a single-carrier modulation is used at the transmitter 11 rather than a multi-carrier modulation, the receiver 15 may implement a single-carrier demodulator. The receiver 15 may further comprise a Space-Time decoder (not illustrated in figure 1) in embodiments in which the receiver 15 is equipped with two or more receive antennas.

The optimal receiver without channel uncertainty (i.e. for channel amplitude and phase perfectly known at the receiver) is a coherent receiver configured to determine an estimate $\hat{m}$ of the original message m by solving the optimization problem defined by:

$$\hat{m} = \text{argmax}_m \, \text{Re}(Ae^{-j\theta}ys(m)^H) \tag{9}$$

Solving the optimization problem in equation (9) may be achieved using a Least-square estimation of the amplitude and phase of the channel using reference signals.

The maximum likelihood detection is implemented in a joint estimation-detection receiver. For complex unknown channel amplitude and phase independent such that the phase $\theta$ is uniformly distributed over $[0,2\pi]$, the maximum likelihood detection may be expressed by:

$$\hat{m} = \text{argmax}_m \, |ys(m)^H| \tag{10}$$

The various embodiments of the invention provide a coded modulation device 20 and a method for constructing one or more linear error correcting codes under non-coherent transmission assumption and optimized for approaching the performance of orthogonal codes.

The quality of an error correcting coding scheme may be evaluated and quantified using a parameter, referred to as a loss factor, and given by:

$$LF\big(C(B,N)\big) = 1 - \rho_{NC,max} \tag{11}$$

The loss factor quantifies the loss in effective signal energy compared to an orthogonal signal set. In equation (11), $\rho_{NC,max}$ designates the maximum non-coherent metric associated with the linear error correcting code C and is given by:

$$\rho_{NC,max} = \max_{m \neq m'} |\rho(m, m')| \tag{12}$$

In equation (12), $\rho(m, m')$ designates a metric determined from pairwise correlations between transmitted vectors $s(m)$ and $s(m')$ and is given by:

$$\rho(m, m') = \frac{1}{N}\big(N_{DMRS} + \sum_{n \in \pi_d} s_n(m)s_n^*(m')\big) \tag{13}$$

In equation (13), $N_{DMRS}$ designates the number of reference symbols comprised in the transmitted vectors and $\pi_d$ designates the sequence of positions of the reference symbols in the transmitted and received vectors.

The performance of the joint estimation-detection receiver may be asymptotically approximated as:

$$\text{Pr}(\hat{m} \neq m|A) \cong N_{min} Q\left(\sqrt{\frac{A^2(1-\rho_{NC,max})}{2\sigma^2}}\right) \tag{14}$$

In equation (14), $N_{min}$ designates the average number of the nearest neighbours or $2^{-B} \sum_{m,m'} In(|\rho(m, m')| = \rho_{NC,max})$, where $In(.)$ is the indicator function.

The embodiments of the invention provide devices and methods for the construction of linear error correcting codes for joint estimation-detection based on the non-coherent detection metric. This provides power codes adapted for low-to-medium spectral efficiency transmissions, approaching the performance of orthogonal codes, while keeping a practical decoding complexity at the receiver 15.

Referring to figure 2, there is provided a coded modulation device 20 for determining one or more linear error correcting codes $C(B,N)$ of length $N$ and rank $B$, a linear error correcting code $C(B, N)$ represented by a generator matrix $G(N, B)$ given in a systematic form according to equation (1).

According to some embodiments, the one or more linear error correcting code may be binary or quaternary.

According to some embodiments, the one or more linear error correcting code may be used to encode control data transmitted over a physical control channel in a transmission system.

Referring to figure 2, the coded modulation device 20 may comprise a calculation unit 201 configured to determine $P \geq 2$ or two or more candidate generator matrices denoted by $G^{(p)}(N^{(p)}, B^{(p)})$ for $p = 1, ...,P$, each candidate generator matrix $G^{(p)}(N^{(p)}, B^{(p)})$ defining a linear error correcting code $C^{(p)}(B^{(p)}, N^{(p)})$ and comprising values $G_{i,j}^{(p)}$ selected from a predefined set of values dependent on a given algebraic structure over which the code is constructed. Each candidate generator matrix $G^{(p)}(N^{(p)}, B^{(p)})$ defines a candidate codebook, denoted by

$$\mathcal{C}^{(p)},$$

and provides a set of codeword vectors, denoted by

$$\left( c_1^{(p)}, ..., c_{Card(\mathcal{C}^{(p)})}^{(p)} \right),$$

from input vectors

$$\left( u_1, ...., u_{Card(\mathcal{C}^{(p)})} \right)$$

The input vectors comprise values selected from the predefined set of values dependent on the given algebraic structure.

The coded modulation device 20 may further comprise a metric determination unit 202 configured to associate a vector metric, denoted by $\rho^{(p)}\left( c_h^{(p)}, c_{h'}^{(p)} \right)$, to each pair of codeword vectors $\left( c_h^{(p)}, c_{h'}^{(p)} \right)$ provided by each candidate generator matrix $G^{(p)}(N^{(p)}, B^{(p)})$ for a predefined modulation scheme $\mathcal{M}$ and to associate a matrix metric, denoted by $M^p(G^{(p)}(N^{(p)}, B^{(p)}))$, to each candidate generator matrix $G^{(p)}(N^{(p)}, B^{(p)})$. The matrix metric $M^p(G^{(p)}(N^{(p)}, B^{(p)}))$ associated with the candidate generator matrix $G^{(p)}(N^{(p)}, B^{(p)})$ is the minimum value among the vector metrics $\rho^{(p)}\left( c_h^{(p)}, c_{h'}^{(p)} \right)$ associated with the pairs of codeword vectors $\left( c_h^{(p)}, c_{h'}^{(p)} \right)$. The codeword vectors are the vectors

$$c_h^{(p)} \in \mathcal{C}^{(p)}$$

and

$$c_{h'}^{(p)} \in \mathcal{C}^{(p)}, c_{h'}^{(p)} \neq c_h^{(p)}$$

provided by the candidate generator matrix $G^{(p)}(N^{(p)}, B^{(p)})$. The matrix metric $M^p(G^{(p)}(N^{(p)}, B^{(p)}))$ associated with the candidate generator matrix $G^{(p)}(N^{(p)}, B^{(p)})$ may be expressed as:

$$M^p\left( G^{(p)}\left(N^{(p)}, B^{(p)}\right)\right) = \operatorname{argmin}_{c_h^{(p)} \in \mathcal{C}^{(p)}; c_{h'}^{(p)} \in \mathcal{C}^{(p)}, c_{h'}^{(p)} \neq c_h^{(p)}} \rho^{(p)}\left( c_h^{(p)}, c_{h'}^{(p)} \right) \tag{15}$$

The coded modulation device 20 may further comprise a selection unit 203 configured to select, among the two or more candidate generator matrices $G^{(p)}(N^{(p)}, B^{(p)})$ with $p = 1, ..., P$, the one or more candidate generator matrices $G^{(sel)}(N^{(sel)}, B^{(sel)})$ that are associated with the highest matrix metric $M^{sel}(G^{(sel)}(N^{(sel)}, B^{(sel)}))$. The selection unit 203 may accordingly select, among the two or more candidate generator matrices $G^{(p)}(N^{(p)}, B^{(p)})$ with $p = 1, ... , P$, the one or more candidate generator matrices that satisfy the optimization problem given by:

$$G^{(sel)}\left(N^{(sel)}, B^{(sel)}\right) = \mathrm{argmax}_{G^{(p)}(N^{(p)}, B^{(p)}), p=1,\ldots,P}\, M^p\left(G^{(p)}\left(N^{(p)}, B^{(p)}\right)\right) \qquad (16)$$

The one or more linear error correcting codes determined by the coded modulation device 20 are the one or more linear error correcting codes $C^{(sel)}(B^{(sel)}, N^{(sel)})$ that are represented by the selected one or more candidate generator matrices $G^{(sel)}(N^{(sel)}, B^{(sel)})$.

According to some embodiments, the vector metric $\rho^{(p)}\left(c_h^{(p)}, c_{h'}^{(p)}\right)$ associated to each pair of codeword vectors $\left(c_h^{(p)}, c_{h'}^{(p)}\right)$ provided by each candidate generator matrix $G^{(p)}(N^{(p)}, B^{(p)})$ may correspond to the non-coherent metric given in equation (14) and determined from pairwise correlations between the codeword vectors $c_h^{(p)}$ and $c_{h'}^{(p)}$ for a predefined modulation scheme $\mathcal{M}$. In such embodiments, each pair of codeword vectors $\left(c_h^{(p)}, c_{h'}^{(p)}\right)$ comprises a first codeword vector $c_h^{(p)}$ and a second codeword vector $c_{h'}^{(p)}$. The calculation unit 201 is configured to determine a first value denoted by $\mathcal{M}\left(c_h^{(p)}\right)$ by mapping the first codeword vector $c_h^{(p)}$ using the predefined modulation scheme $\mathcal{M}$ and to determine a second value denoted by $\mathcal{M}\left(c_{h'}^{(p)}\right)$ by mapping the second candidate vector $c_{h'}^{(p)}$ using the predefined modulation scheme $\mathcal{M}$. The metric determination unit 202 is configured to determine the vector metric $\rho^{(p)}\left(c_h^{(p)}, c_{h'}^{(p)}\right)$ associated with each pair of codeword vectors $\left(c_h^{(p)}, c_{h'}^{(p)}\right)$ as the absolute value of the pairwise correlation between the first value

$$\mathcal{M}\left(c_h^{(p)}\right)$$

and the second value

$$\mathcal{M}\left(c_{h'}^{(p)}\right).$$

In particular, since the constructed error correcting codes are linear before and after the modulation operation, non-coherent metric may be determined as in equation (14) based on the correlations between the all-zero codeword vector and the all non-zero codeword vectors generated by each candidate generator matrix $G^{(p)}(N^{(p)}, B^{(p)})$, the first codeword vector $c_h^{(p)}$ corresponding to the all-zero vector and the second codeword vector $c_{h'}^{(p)}$ corresponding to a non-zero codeword vector.

In particular embodiments using BPSK modulations, the vector metric $\rho^{(p)}\left(c_h^{(p)} = 0, c_{h'}^{(p)}\right)$ associated with the pair of codeword vectors $\left(c_h^{(p)} = 0, c_{h'}^{(p)}\right)$ may be determined as:

$$\rho^{(p)}\left(c_h^{(p)} = 0, c_{h'}^{(p)}\right) = 2w_H\left(c_{h'}^{(p)}\right) - N \qquad (17)$$

In equation (17), $w_H\left(c_{h'}^{(p)}\right)$ stands for the Hamming weight of the codeword vector $c_{h'}^{(p)}$ and corresponds to the number of non-zero components in the codeword vector $c_{h'}^{(p)}$.

In particular embodiments using QPSK modulations, the vector metric $\rho^{(p)}\left(c_h^{(p)} = 0, c_{h\prime}^{(p)}\right)$ associated with the pair of codeword vectors $\left(c_h^{(p)} = 0, c_{h\prime}^{(p)}\right)$ may be determined as:

$$\left|\rho^{(p)}\left(c_h^{(p)} = 0, c_{h\prime}^{(p)}\right)\right| = \sqrt{\left(w_0\left(c_{h\prime}^{(p)}\right) - w_2\left(c_{h\prime}^{(p)}\right)\right)^2 + \left(w_1\left(c_{h\prime}^{(p)}\right) - w_3\left(c_{h\prime}^{(p)}\right)\right)^2} \qquad (18)$$

In equation (18), $w_i\left(c_{h\prime}^{(p)}\right)$ for $i = 0,1,2,3$ designate the number of occurrences of $i$ in the codeword vector $c_{h\prime}^{(p)}$.

According to some embodiments, the selection unit 203 may be configured to select, among the one or more candidate generator matrices $G^{(sel)}(N^{(sel)},B^{(sel)})$ associated with the highest matrix metric $M^{sel}$ $(G^{(sel)}(N^{(sel)},B^{(sel)}))$, the candidate generator matrix $G^{(opt)}(N^{(opt)},B^{(opt)})$ that :

- is associated with the highest matrix metric $M^{sel}$ $(G^{(sel)}(N^{(sel)},B^{(sel)}))$, and
- provides a minimum number $N_{min}$ of pairs of codeword vectors

$$\left(c_h^{(sel)}, c_{h\prime}^{(sel)}\right) \in$$

$$\left(\mathcal{C}^{(sel)}, \mathcal{C}^{(sel)}\right)$$

that are associated with a vector metric $\rho^{(sel)}\left(c_h^{(sel)}, c_{h\prime}^{(sel)}\right)$ equal to the highest matrix metric $M^{sel}$ $(G^{(sel)}(N^{(sel)},B^{(sel)}))$.

The pairs of codeword vectors

$$\left(c_h^{(sel)}, c_{h\prime}^{(sel)}\right) \in \left(\mathcal{C}^{(sel)}, \mathcal{C}^{(sel)}\right)$$

comprise a zero-valued codeword vector $c_h^{(sel)} = 0$ and a non-zero valued codeword vector $c_{h\prime}^{(sel)}$.

According to some embodiments, the linear error correcting code represented by the selected generator matrix $G^{(opt)}(N^{(opt)},B^{(opt)})$ may have the property according to which some dimensions are independent of the information bits (i.e. they are equal to zero). Such property amounts to a reference symbol in the linear error correcting code and may be considered as a positive by-product of the optimization.

According to some embodiments, the search complexity of the two or more candidate generator matrices may be reduced by reducing the candidate set of generator matrices among which the two or more candidate generator matrices are searched. Accordingly, the calculation unit 201 may be configured to previously determine a first set of candidate generator matrices $\Lambda$ comprising two or more candidate generator matrices $G^{(l)}(N^{(l)},B^{(l)})$ with $l = 1, ..., Card(\Lambda)$ and to determine at least one candidate generator matrix $G^{(p)}(N^{(p)},B^{(p)})$ from the first set of candidate generator matrices $\Lambda$. The two or more candidate generator matrices $G^{(l)}(N^{(l)},B^{(l)})$ may be expressed in a systematic form according to equation (1) such that $G^{(l)}\left(N^{(l)}, B^{(l)}\right) = \left(I_{B^{(l)}} \quad G_{B^{(l)} \times N^{(l)} - B^{(l)}}^{(l)}\right)$ with $G_{B^{(l)} \times N^{(l)} - B^{(l)}}^{(l)}$ being a rectangular matrix comprising B(1) lines and $N^{(l)} - B^{(l)}$ rows such that the $k^{th}$ row vector of the rectangular matrix $G_{B^{(l)} \times N^{(l)} - B^{(l)}}^{(l)}$ is

designated by $g_k^{(l)} = \begin{pmatrix} G_{k,1}^{(l)} & G_{k,2}^{(l)} & \cdots & G_{k,N^{(l)}-B^{(l)}}^{(l)} \end{pmatrix}$, with $k = 1, \ldots, B^{(l)}$. The components of the candidate generator matrix $G^{(l)}(N^{(l)},B^{(l)})$ are denoted by $G_{i,j}^{(l)}$ with $i = 1, \ldots, B^{(l)}$ designating the row index and $j = 1, \ldots, N(1)$ designating the column index of the component $G_{i,j}^{(l)}$.

According to some embodiments, the calculation unit 201 may be configured to determine the first set of candidate generator matrices $\Lambda$ by determining candidates for the rows of the candidate generator matrices $G^{(l)}(N^{(l)},B^{(l)})$ among a candidate set of rows denoted by G($\delta$), the candidate set of rows comprising candidate rows $g_k^{(l)}$ for $l = 1, \ldots,$ Card($\Lambda$) and $k = 1, \ldots,$ B(1) such that the candidate rows satisfy the inequality given by:

$$\left| \rho \left( \left( (v_k \ g_k^{(l)}), 0 \right) \right) \right| \leq \delta \tag{19}$$

In equation (19), $v_k$ designates a row vector comprising B(1) components denoted by $vk$ with $h = 1, \ldots,$ B(1) such that $vk = 1$ for $h = k$ and $vk = 0$ for $h \neq k$. The candidate row vectors comprised in the candidate set of rows $G(\delta)$ thereby satisfy a condition related to the non-coherent metric $\rho \left( \left( (v_k \ g_k^{(l)}), 0 \right) \right)$ between the zero-valued vector and the codeword vector comprising a sub-vector $v_k$ and the candidate row vector $g_k^{(l)}$. The notation $g_{k,(l)} = ((v_k \ g_k^{(l)})$ will be used hereinafter to denote a candidate matrix row.

The parameter $\delta$ in equation (19) designates a metric threshold and is previously set such that the metric threshold $\delta$ has a value smaller than or equal to the maximum non-coherent metric $\rho_{NC,max} : \rho_{NC,max} \geq \delta$.

In order to reduce the time for searching the two or more candidate generator matrices, candidates for the rows of the rectangular matrices $G_{B^{(l)} \times N^{(l)}-B^{(l)}}^{(l)}$ may be preselected and the search may be restricted among the candidate set of rows G($\delta$) that comprises candidate matrix rows $g_{k,(l)} = (v_k \ g_k^{(l)})$ satisfying the condition given in equation (20). After searching through all possible combinations of the candidate row vectors $g_k^{(l)}$ for $k = 1, \ldots, B^{(l)}$ (equivalently the candidate matrix rows $g_{k,(l)}$) in the candidate set of rows G($\delta$), if the resulting non-coherent metric is greater than or equal to the metric threshold, the search is stopped and the optimal candidate generator matrix may be output as a result of the search. Accordingly, the search method implements a search algorithm that is provided to scan all possible candidate row vectors $g_k^{(l)}$ for $k = 1, \ldots, B^{(l)}$ and to prune the search by dropping the candidate row vectors that will not lead to a smaller non-coherent metric value along the search.

Accordingly, the calculation unit 201 may be configured to initialize the non-coherent metric value $\rho_{NC,max}$ to a given first value and to initialize the minimum number $N_{min}$ of pairs of codeword vectors associated with a vector metric equal to the highest matrix metric to a given second value. In some embodiments, the given first value and the given second value may be equal to $N + 1$, the initialization consisting in setting $\rho_{NC,max}$ to $= N + 1$ ($\rho_{NC,max} = N + 1$) and $N_{min}$ to $N + 1$ ($N_{min} = N + 1$).

The calculation unit 201 may be configured to then enumerate the elements of the candidate set of rows G($\delta$) as $g_k^{(l)}$ with $l = 1, \ldots,$ Card(G($\delta$)), a candidate matrix row being designated by $g_{k,(l)} = (v_k \ g_k^{(l)})$.

The search for the candidate matrix rows may be based on an iterative search. Denoting by $i(k)$ the current index in the search for the $k^{th}$ candidate row vector $g_k^{(l)}$, the search is constrained by the inequalities given by:

$$i(1) \leq i(2) \leq \cdots \leq i\left(B^{(l)}\right) \tag{20}$$

In a first step, a loop over all values for i(1) and corresponding $g_k^{(i(1))}$ may be performed. For each index i(1), a loop over i(2) ≥ i(1) may be performed and, for each index i(1), a sub-code with information positions 3,B(1) set to zero may be scanned. A maximum non-coherent metric $\rho_{NC,max,1}$ for the sub-code may be computed by searching all codewords in the sub-code. The calculation unit 201 may be configured to perform a first pruning step if the calculation unit 201 determines that the maximum non-coherent metric $\rho_{NC,max,1}$ is smaller than or equal to the initial value $\rho_{NC,max}$ of the non-coherent metric. If so, the generator pair is selected as a candidate for further search. Otherwise the calculation unit 201 returns to the first step.

In a second step, a loop over all values for $i(3) \geq i(2)$ may be performed and for each index $i(3)$ the sub-code with information positions 4, ... , $B^{(l)}$ set to zero may be scanned. A maximum non-coherent metric $\rho_{NC,max,2}$ for the sub-code may be computed by searching all codewords in the sub-code. The calculation unit 201 may be then perform a second pruning step. If the calculation unit 201 determines that the computed maximum non-coherent metric $\rho_{NC,max,2}$ is smaller than or equal to the initial value $\rho_{NC,max}$ of the non-coherent metric, then the generator pair is a candidate for further search. Otherwise, the calculation unit 201 processes the second step.

The calculation unit 201 may be configured to iterate the second step for each row index $k = 5, ... , B^{(l)}$ and perform pruning at each level when the correlation condition consisting in comparing a current computed maximum non-coherent metric $\rho_{NC,max,k}$ with the initial value $\rho_{NC,max}$ of the non-coherent metric is not satisfied. The number of correlations at the maximum value may be also stored during the search. When the search arrives at the level $k = B^{(l)}$, the calculation unit 201 determines :

(i) if the last computed maximum non-coherent metric $\rho_{NC,max,B(l)}$ is smaller than or equal to the initial value $\rho_{NC,max}$ of the non-coherent metric (i.e. if $\rho_{NC,max,B(l)} \leq \rho_{NC,max}$), and

(ii) if the number $N^*_{min}$ of correlations at the maximum value is smaller than $N_{min}$.

If the two conditions (i) and (ii) are satisfied, the calculation unit 201 may be configured to update the initial value of the non-coherent metric to the last computed maximum non-coherent metric such that $\rho_{NC,max} = \rho_{NC,max,B(l)}$ and to update the initial number of correlations $N_{min}$ to the number $N^*_{min}$ of correlations at the maximum value such that $N_{min} = N^*_{min}$. The current code corresponding to the candidate rows satisfying such conditions may be output as the best code found.

In response to the completion of all the loops, if the resulting computed maximum non-coherent metric $\rho_{NC,max,B(l)}$ is lower or equal to the metric threshold $\delta$ ($\rho_{NC,max,B(l)} \leq \delta$), then the optimal code is found. Otherwise, the metric threshold $\delta$ may be incremented and a new iteration of the search is performed using the incremented value of $\delta$.

In some embodiments, the calculation unit 201 may be configured to determine extended codeword vectors from the codeword vectors provided by the selected one or more candidate generator matrices using a code extension by applying a complex or a real Hadamard matrix for higher dimensionality and increased payload size. Accordingly, a linear error correcting code $C^{(sel)}(B^{(sel)},N^{(sel)})$ represented by a selected generator matrix $G^{(sel)}(N^{(sel)},B^{(sel)})$ in $N^{(sel)}$ signaling dimensions may be extended to $E.N^{(sel)}$ dimensions and $B^{(sel)} + \lfloor log_2 E \rfloor$ bits by performing a Kronecker product of the codeword generated by the generator matrix $G^{(sel)}(N^{(sel)},B^{(sel)})$ and any row or column of a complex or real Hadamar matrix. In embodiments using BPSK and QPSK modulations, an extended codeword may be determined as $c(i) = c\left(i \bmod N^{(sel)}\right) e\left(\left\lfloor \dfrac{i}{N^{(sel)}} \right\rfloor\right)$, $i = 1, ... , EN^{(sel)}$. The resulting extended code exhibits the same minimal non-coherent metric as the base code $C^{(sel)}(B^{(sel)},N^{(sel)})$ generated by the generator matrix $G^{(sel)}(N^{(sel)},B^{(sel)})$.

The concatenation of one or more Hadamard codes with any constructed code provides superior error rate performance for the extension bits. Specifically, the $\lfloor log_2 E \rfloor$ extension bits have error-probability that is equivalent to $2^{\lfloor log_2 E \rfloor}$ orthogonal code sequences that differ in the extension bits in that they are orthogonal to each other by such construction. All maximum correlation pairwise error events have the same bit sequence on the extension bits and differing bit sequences in the information bits of the base code. The asymptotic coding gain for the extension bits compared to the base code information bits corresponds to $10log_{10} 1 - \rho_{NC,max}$ where $\rho_{NC,max}$ is the maximum correlation of the base code.

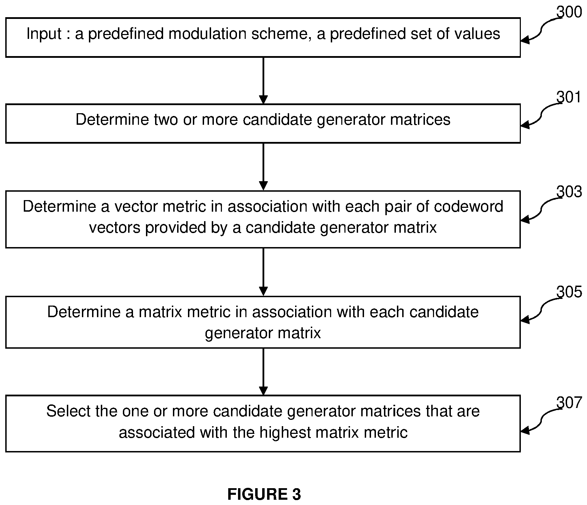

Referring to figure 3, there is also provided a method for determining one or more linear error correcting codes $C(B, N)$ of length $N$ and rank $B$, a linear error correcting code $C(B,N)$ being represented by a generator matrix $G(N,B)$

given in a systematic form according to equation (1).

In some embodiments, the one or more linear error correcting code may be binary or quaternary.

The one or more linear error correcting code may be used to encode control data transmitted over a physical control channel in a transmission system.

At step 301, $P \geq 2$ or two or more candidate generator matrices $G^{(p)}(N^{(p)},B^{(p)})$ for $p = 1, ...,P$ may be determined, each candidate generator matrix $G^{(p)}(N^{(p)},B^{(p)})$ defining a linear error correcting code $C^{(p)}(B^{(p)},N^{(p)})$ and comprising values $G_{i,j}^{(p)}$ selected from a predefined set of values dependent on a given algebraic structure over which the code is constructed. Each candidate generator matrix $G^{(p)}(N^{(p)},B^{(p)})$ defines a candidate codebook denoted by

$$\mathcal{C}^{(p)}$$

and provides a set of codeword vectors denoted by $\left( c_1^{(p)}, ..., c_{Card(\mathcal{C}^{(p)})}^{(p)} \right)$ from input vectors

$$\left( u_1, ...., u_{Card(\mathcal{C}^{(p)})} \right),$$

the input vectors comprising values selected from the predefined set of values which are dependent on the given algebraic structure.

At step 303, a vector metric $\rho^{(p)} \left( c_h^{(p)}, c_{h\prime}^{(p)} \right)$ may be determined in association with each pair $\left( c_h^{(p)}, c_{h\prime}^{(p)} \right)$ of codeword vectors provided by each candidate generator matrix $G^{(p)}(N^{(p)},B^{(p)})$ for a predefined modulation scheme $\mathcal{M}$.

At step 305, a matrix metric $M^p (G^{(p)}(N^{(p)},B^{(p)}))$ may be determined in association with each candidate generator matrix $G^{(p)}(N^{(p)},B^{(p)})$, the matrix metric $M^p ( G^{(p)}(N^{(p)},B^{(p)}))$ associated with the candidate generator matrix $G^{(p)}(N^{(p)},B^{(p)})$ being defined according to equation (15). The codeword vectors represent the vectors

$$c_h^{(p)} \in \mathcal{C}^{(p)}$$

and

$$c_{h\prime}^{(p)} \in \mathcal{C}^{(p)}, c_{h\prime}^{(p)} \neq$$

$$c_h^{(p)}$$

provided by the candidate generator matrix $G^{(p)}(N^{(p)},B^{(p)})$.

At step 307, the one or more candidate generator matrices $G^{(sel)}(N^{(sel)},B^{(sel)})$ that are associated with the highest matrix metric $M^{sel} ( G^{(sel)}(N^{(sel)},B^{(sel)}))$ may be selected among the two or more candidate generator matrices $G^{(p)}(N^{(p)},B^{(p)})$ with $p = 1, ..., P$ according to the maximization problem given in equation (16), the one or more linear error correcting codes $C^{(sel)}(B^{(sel)},N^{(sel)})$ being represented by the selected one or more candidate generator matrices $G^{(sel)}(N^{(sel)}, B^{(sel)})$.

In some embodiments, the vector metric $\rho^{(p)} \left( c_h^{(p)}, c_{h\prime}^{(p)} \right)$ associated with each pair of codeword vectors $\left( c_h^{(p)}, c_{h\prime}^{(p)} \right)$ provided by each candidate generator matrix $G^{(p)}(N^{(p)},B^{(p)})$ may correspond to the non-coherent metric defined by equation (13) and determined from pairwise correlations between the codeword vectors $c_h^{(p)}$ and $c_{h\prime}^{(p)}$ for

a predefined modulation scheme $\mathcal{M}$. In such embodiments, each pair of codeword vectors $\left(c_h^{(p)}, c_{h'}^{(p)}\right)$ comprises a first codeword vector $c_h^{(p)}$ and a second codeword vector $c_{h'}^{(p)}$, the calculation unit 201 being configured to determine a first value denoted by

$$\mathcal{M}\left(c_h^{(p)}\right)$$

by mapping the first codeword vector $c_h^{(p)}$ using the predefined modulation scheme $\mathcal{M}$ and to determine a second value denoted by

$$\mathcal{M}\left(c_{h'}^{(p)}\right)$$

by mapping the second candidate vector $c_{h'}^{(p)}$ using the predefined modulation scheme $\mathcal{M}$, the metric determination unit 202 being configured to determine the vector metric $\rho^{(p)}\left(c_h^{(p)}, c_{h'}^{(p)}\right)$ associated with each pair of codeword vectors $\left(c_h^{(p)}, c_{h'}^{(p)}\right)$ as the absolute value of the pairwise correlation between the first value

$$\mathcal{M}\left(c_h^{(p)}\right)$$

and the second value

$$\mathcal{M}\left(c_{h'}^{(p)}\right).$$

In particular, since the constructed error correcting codes are linear before and after the modulation operation, non-coherent metric may be determined as in equation (13) based on the correlations between the all-zero codeword vector and the all non-zero codeword vectors generated by each candidate generator matrix $G^{(p)}(N^{(p)}, B^{(p)})$, the first codeword vector $c_h^{(p)}$ corresponding to the all-zero valued vector and the second codeword vector $c_{h'}^{(p)}$ corresponding to a non-zero codeword vector.

According to some embodiments, the method may further comprise a step (not represented in figure 3) for selecting, among the one or more candidate generator matrices $G^{(sel)}(N^{(sel)}, B^{(sel)})$ associated with the highest matrix metric $M^{sel}(G^{(sel)}(N^{(sel)}, B^{(sel)}))$, the candidate generator matrix $G^{(opt)}(N^{(opt)}, B^{(opt)})$ that is associated with the highest matrix metric $M^{sel}(G^{(sel)}(N^{(sel)}, B^{(sel)}))$ and that provides a minimum number $N_{min}$ of pairs of codeword vectors

$$\left(c_h^{(sel)}, c_{h'}^{(sel)}\right) \in \left(\mathcal{C}^{(sel)}, \mathcal{C}^{(sel)}\right)$$

associated with a vector metric $\rho^{(sel)}\left(c_h^{(sel)}, c_{h'}^{(sel)}\right)$ equal to the highest matrix metric $M^{sel}(G^{(sel)}(N^{(sel)}, B^{(sel)}))$. The pairs of codeword vectors

$$\left( c_h^{(sel)}, c_{h\prime}^{(sel)} \right) \in \left( C^{(sel)}, C^{(sel)} \right)$$

comprise a zero-valued codeword vector $c_h^{(sel)} = 0$ and a non-zero valued codeword vector $c_{h\prime}^{(sel)}$.

In some embodiments, step 301 may comprise a plurality of sub-steps (not illustrated in figure 3) applied to determine two or more candidate generator matrices with a reduced complexity by reducing the search set for the candidate rows of the candidate generator matrices and determining a reduced first set of candidate generator matrices $\Lambda$ comprising two or more candidate generator matrices $G^{(l)}(N^{(l)}, B^{(l)})$ with $l = 1, ..., Card(\Lambda)$ and determining at least one candidate generator matrix $G^{(p)}(N^{(p)}, B^{(p)})$ from the first set of candidate generator matrices $\Lambda$. The two or more candidate generator matrices $G^{(l)}(N^{(l)}, B^{(l)})$ may be expressed in a systematic form according to equation (1) such that

$$G^{(l)}\left( N^{(l)}, B^{(l)} \right) = \left( I_{B^{(l)}} \quad G_{B^{(l)} \times N^{(l)} - B^{(l)}}^{(l)} \right) \text{ with } G_{B^{(l)} \times N^{(l)} - B^{(l)}}^{(l)} \text{ being a rectangular matrix comprising B(1) lines}$$

and $N^{(l)}$ - $B^{(l)}$ rows such that the $k^{th}$ row vector of the rectangular matrix $G_{B^{(l)} \times N^{(l)} - B^{(l)}}^{(l)}$ is designated by

$$g_k^{(l)} = \left( G_{k,1}^{(l)} \quad G_{k,2}^{(l)} \quad ... \quad G_{k,N^{(l)} - B^{(l)}}^{(l)} \right), \text{ with } k = 1, ..., B^{(l)}, \text{ the components of the candidate generator matrix}$$

$G^{(l)}(N^{(l)}, B^{(l)})$ being denoted by $G_{i,j}^{(l)}$ with $i = 1, ..., B^{(l)}$ designating the row index and $j = 1, ..., N^{(l)}$ designating the column index of the component $G_{i,j}^{(l)}$.

According to some embodiments, the first set of candidate generator matrices $\Lambda$ may be determined by determining candidates for the rows of the candidate generator matrices $G^{(l)}(N^{(l)}, B^{(l)})$ among a candidate set of rows $G(\delta)$, the candidate set of rows comprising candidate rows $g_k^{(l)}$ for $l = 1, ..., Card(\Lambda)$ and $k = 1, ..., B^{(l)}$ such that the candidate rows satisfy the inequality given in equation (19). Candidates for the rows of the rectangular matrices $G_{B^{(l)} \times N^{(l)} - B^{(l)}}^{(l)}$ may be preselected and the search may be restricted among the candidate set of rows $G(\delta)$ that comprises candidate matrix rows $g_{k,(l)} = (v_k \ g_k^{(l)})$ satisfying the condition defined by equation (19). After searching through all possible combinations of the candidate row vectors $g_k^{(l)}$ for $k = 1, ..., B^{(l)}$ (equivalently the candidate matrix rows $g_{k,(l)}$) in the candidate set of rows $G(\delta)$, if the resulting non-coherent metric is greater than or equal to the metric threshold, the search is stopped and the optimal candidate generator matrix may be output as a result of the search. The method thereby implements a search algorithm that attempts to scan all possible candidate row vectors vectors $g_k^{(l)}$ for $k = 1, ..., B^{(l)}$ and prunes the search by dropping the candidate row vectors that will not lead to a smaller non-coherent metric value along the search.

In an initialization sub-step, the non-coherent metric value $\rho_{NC,max}$ may be initialized to a given first value and the minimum number $N_{min}$ of pairs of codeword vectors associated with a vector metric equal to the highest matrix metric may be initialized to a given second value. In some embodiments, the given first value and the given second value may be equal to $N + 1$, the initialization sub-step comprising setting $\rho_{NC,max}$ to $N + 1$ ($\rho_{NC,max} = N + 1$) and $N_{min}$ to $N + 1$ ($N_{min} = N + 1$).

The elements of the candidate set of rows $G(\delta)$ as $g_k^{(l)}$ with $l = 1, ..., Card(G(\delta))$ may be then enumerated, a candidate matrix row being designated by $g_{k,(l)} = (v_k \ g_k^{(l)})$. The following sub-steps of the method are based on an iterative processing for searching for the optimal linear error correcting code and the optimal corresponding generator matrix. The method accordingly implements one or more iterations of sub-steps for each current index $i(k)$ designating the current index in the search for the $k^{th}$ candidate row vector $g_k^{(l)}$. The search is constrained by the inequalities given by equation (20).

More specifically, in a first sub-step, a loop over all values for i(1) and corresponding $g_k^{(i(1))}$ may be performed. For each index $i(1)$, a loop over $i(2) \geq i(1)$ may be performed and for each $i(1)$ a sub-code with information positions 3, ... , $B^{(l)}$ set to zero may be scanned. A maximum non-coherent metric $\rho_{NC,max,1}$ for the sub-code may be computed by searching all codewords in the sub-code. A first pruning step may be performed if it is determined that the maximum non-coherent metric $\rho_{NC,max,1}$ is smaller than or equal to the initial value $\rho_{NC,max}$ of the non-coherent metric. If so, the generator pair is a candidate for further search. Otherwise the first sub-step is processed.

In a second sub-step, a loop over all values for $i(3) \geq i(2)$ may be performed and for each $i(3)$ the sub-code with information positions 4, ... , $B^{(l)}$ set to zero may be scanned. A maximum non-coherent metric $\rho_{NC,max,2}$ for the sub-code may be computed by searching all codewords in the sub-code. A second pruning step may be then performed. If it is determined that the computed maximum non-coherent metric $\rho_{NC,max,2}$ is smaller than or equal to the initial value $\rho_{NC,max}$ of the non-coherent metric, then the generator pair is a candidate for further search. Otherwise, the second sub-step is processed.

The second sub-step may be reiterated for each row index $k = 5, ... , B^{(l)}$ and pruning may be performed at each level when the correlation condition comparing a current computed maximum non-coherent metric $\rho_{NC,max,k}$ with the initial value $\rho_{NC,max}$ of the non-coherent metric is not satisfied. The number of correlations at the maximum value may be also stored during the search. When the search arrives at the level $k = B^{(l)}$, if it is determined that the last computed maximum non-coherent metric $\rho_{NC,max,B(l)}$ is smaller than or equal to the initial value $\rho_{NC,max}$ of the non-coherent metric (i.e. if $\rho_{NC,max,B(l)} \leq \rho_{NC,max}$) and if the number $N_{min}^*$ of correlations at the maximum value is smaller than $N_{min}$, then:

- the initial value of the non-coherent metric may be updated to the last computed maximum non-coherent metric such that $\rho_{NC,max} = \rho_{NC,max,B(l)}$, and

- the initial number of correlations $N_{min}$ may be updated to the number $N_{min}^*$ of correlations at the maximum value such that $N_{min} = N_{min}^*$ .

The current code corresponding to the candidate rows satisfying such conditions may be output as the best code found.

When all the loops are completed, if the resulting computed maximum non-coherent metric $\rho_{NC,max,B(l)} \leq \delta$, then the optimal code is found, otherwise the metric threshold may be incremented and the search repeated using the incremented value of $\delta$.

According to some embodiments, the method may further comprise a step (not represented in figure 3) for determining extended codeword vectors from the codeword vectors provided by the selected one or more candidate generator matrices using a code extension (also referred to as code expansion) by applying a complex or a real Hadamard matrix for higher dimensionality and increased payload size. Accordingly, a linear error correcting code $C^{(sel)}(B^{(sel)}, N^{(sel)})$ represented by a selected generator matrix $G^{(sel)}(N^{(sel)}, B^{(sel)})$ in $N^{(sel)}$ signaling dimensions may be extended to $E.N^{(sel)}$ dimensions and $B^{(sel)} + \lfloor log_2 E \rfloor$ bits by performing a Kronecker product of the codeword generated by the generator matrix $G^{(sel)}(N^{(sel)}, B^{(sel)})$ and any row or column of a complex or real Hadamar matrix. In embodiments using BPSK and QPSK modulations, an extended codeword may be determined as $c(i) = c\left(i \bmod N^{(sel)}\right) e\left(\left\lfloor \frac{i}{N^{(sel)}} \right\rfloor\right)$ , $i = 1, ...,$ $EN^{(sel)}$. The resulting extended code exhibits the same minimum non-coherent metric as the base code $C^{(sel)}(B^{(sel)}, N^{(sel)})$ generated by the generator matrix $G^{(sel)}(N^{(sel)}, B^{(sel)})$.

The following table 1 provides a list of exemplary short block length codes determined according to the various embodiments of the invention for 3-11 bits in 6,7,12,14 and 24 dimensions. The considered modulation schemes, the asymptotic performance metrics, the number of reference symbols (denoted as DMRS) and the generator matrices specifying the parity positions are provided for each constructed code.

| (N, B) modulation | $\rho^*_{NC,max}/N_{min}$ | Loss in dB (compared to orthogonal) | number of DMRS | Generator Matrix (parity positions) |
|---|---|---|---|---|
| (6,3) QPSK | .33333/1 | 1.76 | 0 | 2 3 3 3<br>2 1 2 3 |
| (6,4) QPSK | .33333/13 | 1.76 | 0 | 2 3 3 3<br>1 1 2 3 |
| (6,5) QPSK | .47140/9 | 2.77 | 0 | 2 2 3<br>0 1 2<br>0 2 1 |
| (6,6) QPSK | .66667/1 | 4.77 | 0 | 2 3 3<br>2 3 3<br>0 1 2 |
| (6,7) QPSK | .70544/3 | 5.33 | 0 | 3 3<br>1 1<br>0 3<br>0 2 |
| (6,8) QPSK | .74536/1 | 5.95 | 0 | 3 3<br>1 2<br>1 1<br>3 0 |
| (6,9) QPSK | .74536/1 | 5.95 | 0 | 2<br>1<br>1<br>1<br>1 |
| (7,3) QPSK | .14286/7 | .70 | 0 | 2 2 3 3 3<br>2 3 1 2 3 |
| (7,4) QPSK | .31944/11 | 1.67 | 0 | 2 2 3 3 3<br>1 2 1 2 3 |
| (7,5) QPSK | .42857/8 | 2.43 | 0 | 3 3 3 3<br>1 3 3 3<br>2 0 2 3 |
| (7,6) QPSK | .51508/9 | 3.14 | 0 | 2 2 3 3<br>1 3 1 1<br>2 3 0 3 |
| (7,7) QPSK | .58902/7 | 3.86 | 0 | 3 3 3<br>3 3 3<br>2 3 3<br>0 1 2 |
| (7,8) QPSK | .71429/1 | 5.4407 | 0 | 2 3 3<br>2 3 3<br>2 3 3<br>0 1 2 |

(continued)

| (N, B) modulation | $\rho^*_{NC,max}/N_{min}$ | Loss in dB (compared to orthogonal) | number of DMRS | Generator Matrix (parity positions) |
|---|---|---|---|---|
| (7,9) QPSK | .71429/9 | 5.4407 | 0 | 2 2<br>1 1<br>1 1<br>0 3<br>0 2 |
| (7,10) QPSK | .71429/32 | 5.4407 | 0 | 1 1<br>1 1<br>1 1<br>1 1<br>0 3 |
| (12,4) QPSK | .166667/11 | 0.79 | 1 | 2 1 2 3 3 2 0 1 2 3<br>1 3 0 2 0 3 0 1 2 3 |
| (12,5) QPSK | .33333/9 | 1.76 | 1 | 3 2 1 0 3 3 0 2 0<br>2 3 1 1 3 3 0 2 0<br>3 3 0 1 1 0 2 2 0 |
| (12,6) QPSK | .33333/1 | 1.76 | 0 | 1 2 2 3 3 3 3 3<br>3 2 3 1 2 3 3 3 3<br>2 1 2 2 2 0 1 2 3 |
| (12,7) QPSK | .37268/16 | 2.03 | 0 | 0 0 1 3 0 3 2 2<br>3 3 2 2 1 0 0 0<br>3 2 3 0 1 3 1 0<br>1 3 2 1 2 3 1 0 |
| (12,8) QPSK | .49243/32 | 2.40 | 1 | 2 0 1 0 2 1 3 0<br>3 2 2 1 1 0 0 0<br>3 1 1 2 1 1 2 0<br>2 1 2 1 1 2 1 0 |
| (12,9) QPSK | .5/1 | 3.00 | 0 | 0 2 2 1 2 3 1<br>2 1 2 1 0 0 0<br>3 1 2 0 2 0 0<br>2 1 0 2 3 1 0<br>3 2 2 3 1 2 1 |
| (12,10) QPSK | .52705/14 | 3.25 | 0 | 3 1 3 3 0 0 2<br>1 2 0 0 1 0 2<br>2 1 2 0 1 0 2<br>1 1 1 1 0 2 3<br>2 2 1 2 2 2 3 |
| (12,11) QPSK | .60093/4 | 3.99 | 0 | 2 3 2 2 1 1<br>3 3 2 2 1 1<br>0 3 3 0 2 1<br>1 2 1 2 2 1<br>2 3 3 3 3 1<br>1 3 2 3 1 3 |
| (14,4) QPSK | .14286/1 | 0.67 | 0 | 0 1 1 1 2 2 2 2 3 3 3 3<br>2 1 2 3 0 1 2 3 0 1 2 3 |

(continued)

| (N, B) modulation | $\rho^*_{NC,max}/N_{min}$ | Loss in dB (compared to orthogonal) | number of DMRS | Generator Matrix (parity positions) |
|---|---|---|---|---|
| (14,5) QPSK | .20601/4 | 1.00 | 0 | 0 2 3 1 1 2 2 2 3 0 1<br>0 2 3 1 1 3 0 1 2 2 2<br>3 1 0 0 3 2 1 3 3 0 2 |
| (14,6) QPSK | .3194414 | 1.67 | 0 | 0 1 3 0 2 2 1 3 0 1 2<br>0 1 3 0 3 0 1 2 2 2 1<br>0 1 3 2 0 0 2 1 1 2 3 |
| (14,7) QPSK | .36422/14 | 1.97 | 0 | 1 2 2 2 3 3 3 3 3 3<br>1 2 3 3 2 2 3 3 3 3<br>3 1 2 3 2 3 0 0 2 3<br>1 3 0 0 2 3 1 2 2 0 |
| (14,8) QPSK | .41650/4 | 2.34 | 0 | 1 3 3 0 1 2 0 0 1 2<br>1 3 3 0 2 0 1 2 0 1<br>3 0 2 0 1 1 1 0 2 3<br>1 0 2 0 1 0 2 2 1 3 |
| (24,5) BPSK | .166667/4 | .79 | 1 | 0 0 1 1 1 0 1 1 0 1 1 1 0 0 0 1 0 0 1<br>1 0 0 0 0 1 1 1 0 1 1 1 0 0 0 1 0 0 1<br>1 1 1 1 0 0 1 0 1 0 0 0 1 0 0 1 0 0 1<br>0 1 1 0 0 1 0 1 1 1 0 0 0 1 0 1 0 0 1<br>0 1 1 0 1 0 0 1 0 0 1 0 1 1 0 0 1 0 1 |
| (24,6) BPSK | .25/1 | 1.25 | 1 | 1 1 0 1 0 1 0 1 0 0 1 0 0 1 1 0 0 1<br>1 0 1 0 1 0 1 0 1 0 1 0 0 1 1 0 0 1<br>0 1 1 1 1 0 0 0 0 1 0 1 0 1 1 0 0 1<br>1 1 1 1 0 1 1 0 0 1 0 0 0 0 0 1 0 1<br>0 1 1 0 1 0 0 1 1 0 0 1 1 0 0 1 0 1<br>1 1 1 0 1 0 0 1 1 0 0 1 1 0 0 1 0 1 |
| (24,7) BPSK | .3333/1 | 1.76 | 1 | 0 0 1 1 1 0 0 1 1 1 0 1 0 1 0 0 1<br>1 0 0 0 0 1 0 1 1 1 0 1 0 1 0 0 1<br>1 1 1 1 0 0 0 0 0 0 1 1 0 1 0 0 1<br>1 1 0 0 1 1 1 0 0 0 0 0 1 1 0 0 1<br>1 1 1 1 0 1 1 1 0 0 0 0 0 0 1 0 1<br>1 0 1 0 1 0 0 0 1 0 1 0 1 0 1 0 1<br>1 1 1 0 1 0 0 0 1 0 1 0 1 0 1 0 1 |
| (24,8) BPSK | .333/6 | 1.76 | 1 | 0 0 0 1 1 1 1 1 1 1 1 0 0 0 1<br>1 1 1 1 1 1 1 1 1 1 1 0 0 0 1<br>1 1 1 1 1 0 0 0 0 0 0 0 1 0 0 1<br>1 1 0 0 0 1 1 1 0 0 0 0 1 0 0 1<br>1 0 1 0 0 1 0 0 1 1 0 0 1 0 0 1<br>0 0 1 1 0 0 1 1 1 0 1 0 0 1<br>1 1 0 1 1 1 0 0 1 0 0 1 0 1<br>0 0 0 1 1 1 1 0 0 1 0 0 1 1 0 1 |

(continued)

| (N, B) modulation | $\rho^*_{NC,max}/N_{min}$ | Loss in dB (compared to orthogonal) | number of DMRS | Generator Matrix (parity positions) |
|---|---|---|---|---|
| (24,9) BPSK | .333/32 | 1.76 | 1 | 111111100000000<br>111100011100000<br>110011011010000<br>101010110110000<br>100101101110000<br>011010111001000<br>100110111000100<br>101001111000010<br>101000010101110 |
| (24,10) BPSK | .333/160 | 1.76 | 1 | 11111110000000<br>11110001110000<br>11001101101000<br>10101011011000<br>10010110111000<br>01101011100100<br>11000111010100<br>01011100110100<br>10100111100010<br>01101101010010 |
| (24,11) BPSK | .333/352 | 1.76 | 1 | 1111111000000<br>1111000111000<br>1100110110100<br><br>1010101101100<br>1001011011100<br>0110101110010<br>1100011101010<br>0101110011010<br>0001111100110<br>1011100010110<br>0111001001110 |

The table shows that the codes constructed according to the embodiments of the invention have a loss within 2dB with respect to perfect orthogonal constellations. Many codes exhibit reference symbols that may be exploited for channel state information retrieval without coding loss.

In an application of the invention to wireless communications, the one or more constructed linear error correcting codes $C(B, N)$ may be used for mapping data to OFDM time-frequency grids comprising $L$ symbols and $K$ frequency carriers with or without DFT precoding.

According to some embodiments, the constructed linear error correcting codes may be combined with frequency hopping over two different parts of the operated spectrum (bandwidth part in the context of 3GPP 5G New Radio). By splitting the time resources in half, the same code sequence may be repeated in the two hops. Considering the example of a transmission of $B = 11$ bits and a total transmission of $L = 14$ symbols, 7 symbols may be used in each hop. This would require a code $C(12,9)$ with two expansion bits when expanding in time and a code $C(7,8)$ with 3 expansion bits when expanding in frequency. In such example, time expansion is more efficient because of the higher coding gain of the base code.

In embodiments in which orthonormal expansions are used, multiplexing multiple users sharing the same time and frequency allocations may be considered. For example for the length 7 or 14 symbol transmissions cases with length 12 codes $C(12, B - 2)$ and $C(12,B - 3)$ with expansions of 2 and 3 bits respectively may be used. This only requires 4 and 8 dimensions out of 7 and 14 leaving 3 and 6 dimensions unused in the orthonormal expansion. As a result, a second user could use codes of $C(12,B - 1)$ for $L = 7$ with one bit of expansion or $C(12, B - 2)$ for $L = 14$ with 2 bits of expansion to fill the remaining resources. In general, channel quality conditions may be exploited to allow for multiple-access on the same time-frequency resources. Specifically, codes with less coding gains may be allocated to users with higher channel quality or equivalently higher transmit power headroom.

In an exemplary application of the invention, a first transmission of $B$ bits in $KL$ dimensions using ones of the constructed codes for $L$ = 4,5, ...,14 and $K$ = 12 can be considered. Such an example corresponds to a numerology which is similar to the PUCCH formats 3 and 4. Two possibilities may be used for all lengths $L$ and two specific possibilities may be used for $L$ = 7 and $L$ = 14. For the first case, codes of lengths 6 and 12 from Table 1 whose outputs are mapped to 6 resource elements or 12 resource elements of the first physical resource block, may be used.

For length 6 codes, orthonormal expansion of $E$ = $2L$ may be used and for length 12 codes, an orthonormal expansion of $E$ = $L$ may be used.

For $L$ = 8, ...,14, the code $C(6, B - 4)$ and an orthonormal expansion of $\lfloor \log_2 E \rfloor = 4$ expansion bits or the code $C(12, B - 3)$ and an orthonormal expansion of $\lfloor \log_2 E \rfloor = 3$ bits may be used.

For $L$ = 4,5,6,7 the code $C(6, B-3)$ and an orthonormal expansion of $\lfloor \log_2 E \rfloor = 3$ expansion bits or the code $C(12, B - 2)$ and an orthonormal expansion of $\lfloor \log_2 E \rfloor = 2$ bits may be used.

For the case of $B$ = 11 bits, the 4 cases would yield codes with correlations of 0.70544 for the code $C(6,7)$, 0.74536 for the code $C(6,8)$, 0.49423 for the code $C(12,8)$, and 0.5 for the code $C(12,9)$. From Table 1, 3dB improvement with the length 12 codes at the expense of higher complexity is reported.

In the second case with $L$ = 7 and 14, the output of the code may be mapped to the dimensions in time first followed by frequency. These time-frequency dimensions are referred to as Resource Elements (RE) in LTE/NR . An expansion of $E$ = 12 with a code C(7,B - 3) or a code $C(14, B-3)$ may be used.

For $B$ = 11 bits, the provided codes have correlations 0.71429 and .41650, which provides a significant benefit from the more powerful code.

Interestingly, the case of the code $C(14,8)$ is significantly better than the code C(12,8) when mapping to the full 14x12 dimensions of the resource grid.

The devices and methods described herein may be implemented by various means. For example, these techniques may be implemented in hardware, software, or a combination thereof. For a hardware implementation, the processing elements of the coded modulation device 20 can be implemented for example according to a hardware-only configuration (for example in one or more FPGA, ASIC, or VLSI integrated circuits with the corresponding memory) or according to a configuration using both VLSI and Digital Signal Processor (DSP).

Furthermore, the method described herein can be implemented by computer program instructions supplied to the processor of any type of computer to produce a machine with a processor that executes the instructions to implement the functions/acts specified herein. These computer program instructions may also be stored in a computer-readable medium that can direct a computer to function in a particular manner. To that end, the computer program instructions may be loaded onto a computer to cause the performance of a series of operational steps and thereby produce a computer implemented process such that the executed instructions provide processes for implementing the functions specified herein.

**Claims**

1. A coded modulation device (20) for determining one or more linear error correcting codes, wherein the coded modulation device comprises:

   - a calculation unit (201) configured to determine two or more candidate generator matrices, each candidate generator matrix defining a linear error correcting code and comprising values selected from a predefined set of values, each candidate generator matrix providing a set of codeword vectors from input vectors, said input vectors comprising values selected from said predefined set of values;
   - a metric determination unit (202) configured to associate a vector metric to each pair of codeword vectors provided by each candidate generator matrix for a predefined modulation scheme and to associate a matrix metric to each candidate generator matrix, a pair of codeword vectors comprising a zero-valued codeword vector and a non-zero valued codeword vector, a matrix metric associated with a candidate generator matrix being the minimum value among the vector metrics associated with the pairs of codeword vectors provided by said candidate generator matrix;
   - a selection unit (203) configured to select the one or more candidate generator matrices that are associated with the highest matrix metric among said two or more candidate generator matrices;

   wherein the one or more linear error correcting codes are represented by said selected one or more candidate generator matrices.

2. The coded modulation device of claim 1, wherein the selection unit (203) is configured to select, among said one or more candidate generator matrices associated with the highest matrix metric, the candidate generator matrix that is associated with the highest matrix metric and that provides a minimum number of pairs of codeword vectors that are associated with a vector metric equal to said highest matrix metric.

3. The coded modulation device of claim 1, wherein the calculation unit (201) is configured to previously determine a first set of candidate generator matrices comprising two or more candidate generator matrices and to determine at least one candidate generator matrix from said first set of candidate generator matrices.

4. The device of any preceding claim, wherein the calculation unit (201) is configured to determine extended codeword vectors from the codeword vectors provided by said selected one or more candidate generator matrices using a code extension by applying a complex or a real Hadamard matrix of one or more codes.

5. The device of any preceding claim, wherein each pair of codeword vectors comprises a first codeword vector and a second codeword vector, the calculation unit (201) being configured to determine a first value by mapping said first codeword vector using said predefined modulation scheme and to determine said second value by mapping said second candidate vector using said predefined modulation scheme, the metric determination unit (202) being configured to determine the vector metric associated with each pair of codeword vectors as the absolute value of the pairwise correlation between the first value and the second value.

6. The device of any preceding claim, wherein the linear error correcting code is binary or quaternary code.

7. The device of any preceding claim, wherein the linear error correcting code is used to encode control data transmitted over a physical control channel in a transmission system.

8. A computer-implemented method for determining one or more linear error correcting codes, wherein the method comprises:

- determining (301) two or more candidate generator matrices, each candidate generator matrix defining a linear error correcting code and comprising values selected from a predefined set of values, each candidate generator matrix providing a set of codeword vectors from input vectors, said input vectors comprising values selected from said predefined set of values;
- determining (303) a vector metric in association with each pair of codeword vectors provided by each candidate generator matrix for a predefined modulation scheme, a pair of codeword vectors comprising a zero-valued codeword vector and a non-zero valued codeword vector;
- determining (305) a matrix metric in association with each candidate generator matrix, a matrix metric associated with a candidate generator matrix being the minimum value among the vector metrics associated with the pairs of codeword vectors provided by said candidate generator matrix;
- selecting (307) the one or more candidate generator matrices that are associated with the highest matrix metric among said two or more candidate generator matrices, the one or more linear error correcting codes are represented by said selected one or more candidate generator matrices.

**Patentansprüche**

1. Vorrichtung für codierte Modulation (20) zum Bestimmen von einem oder mehreren linearen Fehlerkorrekturcodes, wobei die Vorrichtung für codierte Modulation umfasst:

- eine Berechnungseinheit (201), die dafür konfiguriert ist, zwei oder mehr Kandidatengeneratormatrizen zu bestimmen, wobei jede Kandidatengeneratormatrix einen linearen Fehlerkorrekturcode definiert und Werte umfasst, die aus einer vordefinierten Menge von Werten ausgewählt sind, wobei jede Kandidatengeneratormatrix eine Menge von Codewortvektoren aus Eingabevektoren bereitstellt, wobei die Eingabevektoren Werte umfassen, die aus der vordefinierten Menge von Werten ausgewählt wurden;
- eine Metrik-Bestimmungseinheit (202), die dafür konfiguriert ist, jedem Paar von Codewortvektoren, das durch jede Kandidatengeneratormatrix für ein vordefiniertes Modulationsschema bereitgestellt wird, eine Vektormetrik zuzuordnen und jeder Kandidatengeneratormatrix eine Matrixmetrik zuzuordnen, wobei ein Paar von Codewortvektoren einen nullwertigen Codewortvektor und einen nicht nullwertigen Codewortvektor umfasst, wobei eine einer Kandidatengeneratormatrix zugeordnete Matrixmetrik der minimale Wert unter den Vektormetriken ist, die den durch die Kandidatengeneratormatrix bereitgestellten Paaren von Codewortvektoren zugeordnet sind;

- eine Auswahleinheit (203), die dafür konfiguriert ist, die eine oder die mehreren Kandidatengeneratormatrizen unter den zwei oder mehr Kandidatengeneratormatrizen- auszuwählen, der bzw. denen die höchste Matrixmetrik zugeordnet ist;

wobei der eine oder die mehreren linearen Fehlerkorrekturcodes durch die eine oder die mehreren ausgewählte(n) Kandidatengeneratormatrizen dargestellt werden.

2. Vorrichtung für codierte Modulation nach Anspruch 1, wobei die Auswahleinheit (203) dafür konfiguriert ist, unter der einen oder den mehreren Kandidatengeneratormatrizen, der bzw. denen die höchste Matrixmetrik zugeordnet ist, diejenige Kandidatengeneratormatrix auszuwählen, der die höchste Matrixmetrik zugeordnet ist und die eine minimale Anzahl von Paaren von Codewortvektoren bereitstellt, denen eine Vektormetrik zugeordnet sind, die gleich der höchsten Matrixmetrik ist.

3. Vorrichtung für codierte Modulation nach Anspruch 1, wobei die Berechnungseinheit (201) dafür konfiguriert ist, vorher eine erste Menge von Kandidatengeneratormatrizen zu bestimmen, die zwei oder mehr Kandidatengeneratormatrizen umfasst, und mindestens eine Kandidatengeneratormatrix aus der ersten Menge von Kandidatengeneratormatrizen zu bestimmen.

4. Vorrichtung nach einem der vorhergehenden Ansprüche, wobei die Berechnungseinheit (201) dafür konfiguriert ist, erweiterte Codewortvektoren aus den Codewortvektoren zu bestimmen, die durch die ausgewählte(n) eine oder mehreren Kandidatengeneratormatrizen bereitgestellt werden, und zwar unter Verwendung einer Code-Erweiterung durch Anwenden einer komplexen oder einer reellen Hadamard-Matrix eines oder mehrerer Codes.

5. Vorrichtung nach einem der vorhergehenden Ansprüche, wobei jedes Paar von Codewortvektoren einen ersten Codewortvektor und einen zweiten Codewortvektor umfasst, wobei die Berechnungseinheit (201) dafür konfiguriert ist, einen ersten Wert durch Abbilden des ersten Codewortvektors unter Verwendung des vordefinierten Modulationsschemas zu bestimmen und um den zweiten Wert durch Abbilden des zweiten Kandidatenvektors unter Verwendung des vordefinierten Modulationsschemas zu bestimmen, wobei die Metrik-Bestimmungseinheit (202) dafür konfiguriert ist, die jedem Paar von Codewortvektoren zugeordnete Vektormetrik als den absoluten Betrag der paarweisen Korrelation zwischen dem ersten Wert und dem zweiten Wert zu bestimmen.

6. Vorrichtung nach einem der vorhergehenden Ansprüche, wobei der lineare Fehlerkorrekturcode ein binärer oder quaternärer Code ist.

7. Vorrichtung nach einem der vorhergehenden Ansprüche, wobei der lineare Fehlerkorrekturcode verwendet wird, um Steuerungsdaten zu codieren, die über einen physischen Steuerkanal in einem Übertragungssystem übertragen werden.

8. Computerimplementiertes Verfahren zum Bestimmen von einem oder mehreren linearen Fehlerkorrekturcodes, wobei das Verfahren umfasst:

- Bestimmen (301) von zwei oder mehr Kandidatengeneratormatrizen, wobei jede Kandidatengeneratormatrix einen linearen Fehlerkorrekturcode definiert und Werte umfasst, die aus einer vordefinierten Menge von Werten ausgewählt sind, wobei jede Kandidatengeneratormatrix eine Menge von Codewortvektoren aus Eingabevektoren bereitstellt, wobei die Eingabevektoren Werte umfassen, die aus der vordefinierten Menge von Werten ausgewählt wurden;
- Bestimmen (303) einer Vektormetrik in Zuordnung zu jedem Paar von Codewortvektoren, die durch jede Kandidatengeneratormatrix für ein vordefiniertes Modulationsschema bereitgestellt werden, wobei ein Paar von Codewortvektoren einen nullwertigen Codewortvektor und einen nicht-nullwertigen Codewortvektor umfasst;
- Bestimmen (305) einer Matrixmetrik in Zuordnung zu jeder Kandidatengeneratormatrix, wobei eine einer Kandidatengeneratormatrix zugeordnete Matrixmetrik der minimale Wert unter den Vektormetriken ist, die den durch die Kandidatengeneratormatrix bereitgestellten Paaren von Codewortvektoren zugeordnet sind;
- Auswählen (307) der einen oder der mehreren Kandidatengeneratormatrizen unter den zwei oder mehr Kandidatengeneratormatrizen, der bzw. denen die höchste Matrixmetrik zugeordnet ist, wobei der eine oder die mehreren linearen Fehlerkorrekturcodes durch die eine oder die mehreren ausgewählte(n) Kandidatengeneratormatrizen dargestellt werden.

**Revendications**

1. Dispositif de modulation codée (20) pour déterminer un ou plusieurs codes de correction d'erreur linéaires, dans lequel le dispositif de modulation codée comprend :

   - une unité de calcul (201) configurée pour déterminer deux matrices génératrices candidates ou plus, chaque matrice génératrice candidate définissant un code de correction d'erreur linéaire et comprenant des valeurs sélectionnées parmi un ensemble prédéfini de valeurs, chaque matrice génératrice candidate fournissant un ensemble de vecteurs de mot code à partir de vecteurs d'entrée, lesdits vecteurs d'entrée comprenant des valeurs sélectionnées parmi ledit ensemble prédéfini de valeurs ;
   - une unité de détermination de mesure (202) configurée pour associer une mesure vectorielle à chaque paire de vecteurs de mot code fournie par chaque matrice génératrice candidate pour un schéma de modulation prédéfini et pour associer une mesure matricielle à chaque matrice génératrice candidate, une paire de vecteurs de mot code comprenant un vecteur de mot code de valeur nulle et un vecteur de mot code de valeur non nulle, une mesure matricielle associée à une matrice génératrice candidate étant la valeur minimum parmi les mesures vectorielles associées aux paires de vecteurs de mot code fournis par ladite matrice génératrice candidate ;
   - une unité de sélection (203) configurée pour sélectionner les une ou plusieurs matrices génératrices candidates qui sont associées à la mesure matricielle la plus élevée parmi lesdites deux matrices génératrices candidates ou plus ;

   dans lequel les un ou plusieurs codes de correction d'erreur linéaires sont représentés par lesdites une ou plusieurs matrices génératrices candidates sélectionnées.

2. Dispositif de modulation codée selon la revendication 1, dans lequel l'unité de sélection (203) est configurée pour sélectionner, parmi lesdites une ou plusieurs matrices génératrices candidates associées à la mesure matricielle la plus élevée, la matrice génératrice candidate qui est associée à la mesure matricielle la plus élevée et qui fournit un nombre minimum de paires de vecteurs de mot code qui sont associés à une mesure vectorielle égale à ladite mesure matricielle la plus élevée.

3. Dispositif de modulation codée selon la revendication 1, dans lequel l'unité de calcul (201) est configurée pour déterminer préalablement un premier ensemble de matrices génératrices candidates comprenant deux matrices génératrices candidates ou plus et pour déterminer au moins une matrice génératrice candidate parmi ledit premier ensemble de matrices génératrices candidates.

4. Dispositif selon l'une quelconque des revendications précédentes, dans lequel l'unité de calcul (201) est configurée pour déterminer des vecteurs de mot code étendus à partir des vecteurs de mot code fournis par lesdites une ou plusieurs matrices génératrices candidates sélectionnées en utilisant une extension de code en appliquant une matrice de Hadamard à coefficients complexes ou réels d'un ou de plusieurs codes.

5. Dispositif selon l'une quelconque des revendications précédentes, dans lequel chaque paire de vecteurs de mot code comprend un premier vecteur de mot code et un second vecteur de mot code, l'unité de calcul (201) étant configurée pour déterminer une première valeur en effectuant un mappage dudit premier vecteur de mot code en utilisant ledit schéma de modulation prédéfini et pour déterminer ladite seconde valeur en en effectuant un mappage dudit second vecteur candidat en utilisant ledit schéma de modulation prédéfini, l'unité de détermination de mesure (202) étant configurée pour déterminer la mesure vectorielle associée à chaque paire de vecteurs de mot code en tant que valeur absolue de la corrélation par paire entre la première valeur et la seconde valeur.

6. Dispositif selon l'une quelconque des revendications précédentes, dans lequel le code de correction d'erreur linéaire est un code binaire ou quaternaire.

7. Dispositif selon l'une quelconque des revendications précédentes, dans lequel le code de correction d'erreur linéaire est utilisé pour coder des données de commande transmises sur un canal de commande physique dans un système de transmission.

8. Procédé mis en oeuvre par ordinateur pour déterminer un ou plusieurs codes de correction d'erreur linéaires, dans lequel le procédé comprend :

- la détermination (301) de deux matrices génératrices candidates ou plus, chaque matrice génératrice candidate définissant un code de correction d'erreur linéaire et comprenant des valeurs sélectionnées parmi un ensemble prédéfini de valeurs, chaque matrice génératrice candidate fournissant un ensemble de vecteurs de mot code à partir de vecteurs d'entrée, lesdits vecteurs d'entrée comprenant des valeurs sélectionnées parmi ledit ensemble prédéfini de valeurs ;
- la détermination (303) d'une mesure vectorielle en association avec chaque paire de vecteurs de mot code fournis par chaque matrice génératrice candidate pour un schéma de modulation prédéfini, une paire de vecteurs de mot code comprenant un vecteur de mot code de valeur nulle et un vecteur de mot code de valeur non nulle ; et
- la détermination (305) d'une mesure matricielle en association avec chaque matrice génératrice candidate, une mesure matricielle associée à une matrice génératrice candidate étant la valeur minimum parmi les mesures vectorielles associées aux paires de vecteurs de mot code fournies par ladite matrice génératrice candidate ; et
- la sélection (307) des une ou plusieurs matrices génératrices candidates qui sont associées à la mesure matricielle la plus élevée parmi lesdites deux matrices génératrices candidates ou plus, les un ou plusieurs codes de correction d'erreur linéaires étant représentés par lesdites une ou plusieurs matrices génératrices candidates sélectionnées.

**100**

**FIGURE 1**

**FIGURE 2**

Input : a predefined modulation scheme, a predefined set of values    300

Determine two or more candidate generator matrices    301

Determine a vector metric in association with each pair of codeword vectors provided by a candidate generator matrix    303

Determine a matrix metric in association with each candidate generator matrix    305

Select the one or more candidate generator matrices that are associated with the highest matrix metric    307

**FIGURE 3**

**EP 3 955 482 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3291449 A1